# EUROPEAN PATENT APPLICATION

(11) **EP 4 700 759 A1**
(43) Date of publication of application: **25.02.2026**
(21) Application number: 25197438.2
(22) Date of filing: 21.08.2025
(51) Int. Cl.: G09G 3/3233

(54) **DISPLAY PANEL AND DISPLAY DEVICE**

(30) Priority: 23.08.2024 CN 202411166384
(71) Applicant: Tianma Advanced Display Technology Institute (Xiamen) Co., Ltd., 361101 Xiamen (CN)
(72) Inventor: JIA, Zhenyu, Xiamen, Fujian, 361101 (CN); XU, Mingyan, Xiamen, Fujian, 361101 (CN); XI, Kerui, Xiamen, Fujian, 361101 (CN); WU, Tianyi, Xiamen, Fujian, 361101 (CN); ZHAI, Yingteng, Xiamen, Fujian, 361101 (CN); HUANG, Jiali, Xiamen, Fujian, 361101 (CN)
(74) Representative: Germain Maureau

(57) **Abstract**

A display panel and a display device are provided. The display panel includes a display area being arranged with pixels electrically connected to a pixel circuit; and first signal terminals arranged along a first direction and first signal lines respectively connected to the first signal terminals. The first signal terminals are configured to provide a first power voltage signal to the pixel circuit through the first signal lines. The first signal terminals include a first group of signal terminals and a second group of signal terminals, a number of the first signal terminals included in the second group of signal terminals is greater than a number of the first signal terminals included in the first group of signal terminals, and along the first direction, the first group of signal terminals are located between the second group of signal terminals and an edge of the display panel.

## Description

This application claims the priority of Chinese Patent Application No. 202411166384.4, filed on August 23, 2024.

### TECHNICAL FIELD

The present disclosure generally relates to the field of display technologies and, more particularly, relates to a display panel and a display device.

### BACKGROUND

With the continuous development of science and technology, more and more display products, such as mobile phones, tablets, laptops and smart wearable devices, are widely used in people's daily life and work, bringing great convenience to people's daily life and work, and becoming an indispensable and import tool for people today.

Currently, how to improve the uniformity of display brightness and enhance the display effect of display products has become one of the technical problems that need to be solved urgently.

### SUMMARY

In view of the above issues, embodiments of the present disclosure provide a display panel and a display device to improve the uniformity of display brightness and enhance the display effect.

One aspect of the present disclosure provides a display panel. The display panel includes a display area. A plurality of pixels are arranged in the display area, and the plurality of pixels are electrically connected to a pixel circuit. The display panel also includes a plurality of first signal terminals arranged along a first direction and a plurality of first signal lines respectively connected to the plurality of first signal terminals. The plurality of first signal terminals are configured to provide a first power voltage signal to the pixel circuit through the plurality of first signal lines, the plurality of first signal lines extend along a second direction, and the first direction and the second direction intersect and are parallel to a light-emitting surface of the display panel. The plurality of first signal terminals include a first group of signal terminals and a second group of signal terminals; a number of the first signal terminals included in the second group of signal terminals is greater than a number of the first signal terminals included in the first group of signal terminals; and along the first direction, the first group of signal terminals are located between the second group of signal terminals and an edge of the display panel.

Another aspect of the present disclosure includes a display device. The display device includes a display panel. The display panel includes a display area. A plurality of pixels are arranged in the display area, and the plurality of pixels are electrically connected to a pixel circuit. The display panel also includes a plurality of first signal terminals arranged along a first direction and a plurality of first signal lines respectively connected to the plurality of first signal terminals. The plurality of first signal terminals are configured to provide a first power voltage signal to the pixel circuit through the plurality of first signal lines, the plurality of first signal lines extend along a second direction, and the first direction and the second direction intersect and are parallel to a light-emitting surface of the display panel. The plurality of first signal terminals include a first group of signal terminals and a second group of signal terminals; a number of the first signal terminals included in the second group of signal terminals is greater than a number of the first signal terminals included in the first group of signal terminals; and along the first direction, the first group of signal terminals are located between the second group of signal terminals and an edge of the display panel.

Other embodiments in the summary are as disclosed in the claims as appended.

By means of the above technical solutions, in the display panel and display device provided by the present disclosure, a plurality of first signal terminals is provided in the display panel, and the first signal terminals may include a first group of signal terminals arranged along the first direction adjacent to the edge of the display panel, and a second group of signal terminals arranged along the first direction away from the edge of the display panel. Compared with the method of transmitting the power supply voltage signal only through one first signal terminal, the method of introducing multiple first signal terminals and corresponding multiple first signal lines in the present disclosure may be conducive to improving the transmission rate of the first power voltage signal and reducing the overall voltage drop of the first power supply voltage signal, thereby weakening or avoiding the display unevenness caused by the voltage drop problem of the first power voltage signal of the display panel.

### BRIEF DESCRIPTION OF THE DRAWINGS

To illustrate the technical solutions in the embodiments of the present disclosure more clearly, the following briefly introduces the accompanying drawings used in the description of the embodiments. Obviously, the accompanying drawings in the following description are only some embodiments of the present disclosure, for those of ordinary skill in the art, other drawings can also be obtained from these drawings without creative effort.

The structures, proportions, sizes, etc. shown in the drawings of this specification are only used to match the contents disclosed in the specification for people familiar with this technology to understand and read, and are not used to limit the restrictive conditions that may be implemented in the present disclosure. Therefore, they have no technical substantive significance. Any structural modification, change in proportional relationship or adjustment of size should still fall within the scope of the technical content disclosed in the present disclosure without affecting the effects and purposes that may be achieved by the present disclosure.
FIG. 1 illustrates an exemplary display panel according to various embodiments of the present disclosure;
FIG. 2 illustrates another exemplary pixel circuit according to various embodiments of the present disclosure;
FIG. 3 illustrates a BB-sectional of the display panel in FIG. 1;
FIG. 4 illustrates another exemplary display panel according to various embodiments of the present disclosure;
FIG. 5 illustrates another exemplary display panel according to various embodiments of the present disclosure;
FIG. 6 illustrates another exemplary display panel according to various embodiments of the present disclosure;
FIG. 7 illustrates another exemplary display panel according to various embodiments of the present disclosure;
FIG. 8 illustrates another exemplary display panel according to various embodiments of the present disclosure;
FIG. 9 illustrates an exemplary connection of the first signal line and the first connection line in FIG. 8;
FIG. 10 illustrates another exemplary display panel according to various embodiments of the present disclosure;
FIG. 11 illustrates an exemplary connection of the first signal line, the first connection line and the second connection line in FIG. 10;
FIG. 12 illustrates an exemplary positional relationship of the first signal line and the second signal line according to various embodiments of the present disclosure ;
FIG. 13 illustrates an exemplary positional relationship of the first signal line, the second signal line and the second connection line according to various embodiments of the present disclosure;
FIG. 14 illustrates another exemplary positional relationship of the first signal line, the second signal line and the second connection line according to various embodiments of the present disclosure;
FIG. 15 illustrates an exemplary pixel circuit according to various embodiments of the present disclosure;
FIG. 16 illustrates an exemplary time sequence corresponding to FIG. 15;
FIG. 17 illustrates another exemplary pixel circuit according to various embodiments of the present disclosure;
FIG. 18 illustrates an exemplary connection between the pulse amplitude modulation circuit and the pulse width modulation circuit according to various disclosed embodiments of the present disclosure;
FIG. 19 illustrates another exemplary connection between the pulse amplitude modulation circuit and the pulse width modulation circuit according to various disclosed embodiments of the present disclosure;
FIG. 20 illustrates an exemplary connection between the pulse amplitude modulation circuit and the pulse width modulation circuit according to various disclosed embodiments of the present disclosure;
FIG. 21 illustrates an exemplary connection between the second signal terminal and the first connection member according to various embodiments of the present disclosure;
FIG. 22 illustrates an exemplary CC-sectional view of the display panel in FIG. 2;
FIG. 23 illustrates an exemplary display device according to various embodiments of the present disclosure;
FIG. 24 illustrates another exemplary display device according to various embodiments of the present disclosure; and
FIG. 25 illustrates another exemplary display device according to various embodiments of the present disclosure.

### DETAILED DESCRIPTION

To more clearly understand the above-mentioned purpose, features and advantages of the present disclosure, the scheme of the present disclosure will be further described below. It should be noted that, in the absence of conflict, the embodiments of the present disclosure and the features in the embodiments may be combined with each other.

In the following description, many specific details are set forth to facilitate a full understanding of the present disclosure, but the present disclosure may also be implemented in other ways different from those described herein. Obviously, the embodiments in the specification are only part of the embodiments of the present disclosure, not all of the embodiments.

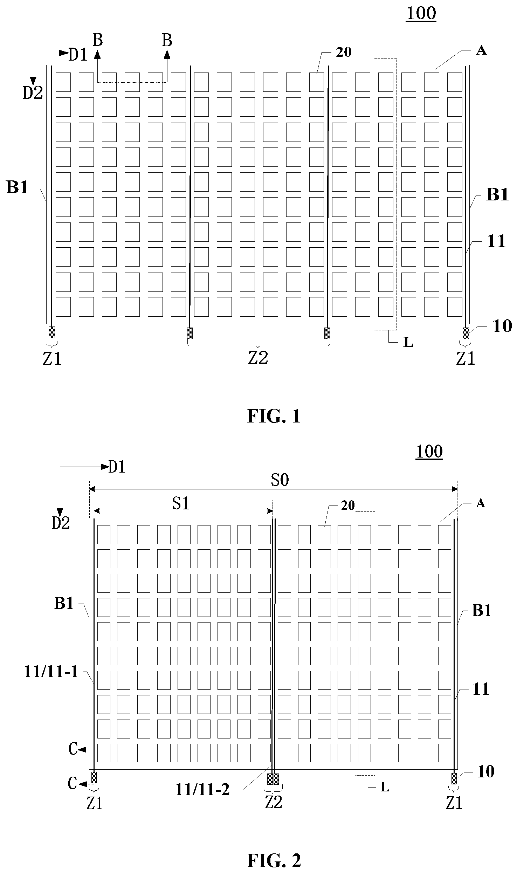

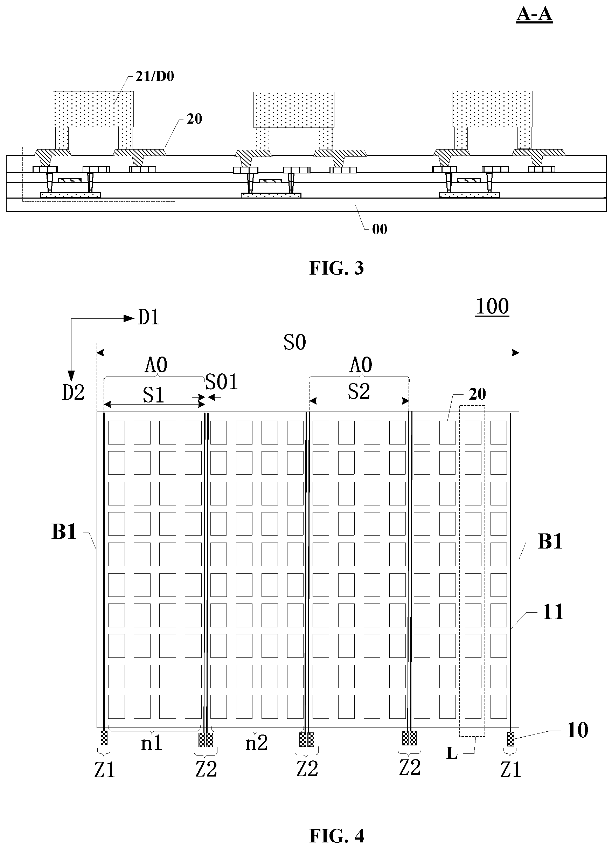

The present disclosure provides a display panel and a display device. FIG. 1 shows a structural schematic diagram of an exemplary display panel according to various embodiments of the present disclosure. FIG. 2 shows the structural schematic diagram of another exemplary display panel according to various embodiments of the present disclosure. FIG. 3 shows a BB-sectional view of the display panel provided by FIG. 1.

As shown in FIGS. 1-3, a display panel 100 provided by the present disclosure may include a display area A. A plurality of pixels 21 may be arranged in the display area A, and a pixel of the plurality of pixels 21 may be electrically connected to a pixel circuit 20.

The display panel 100 may also include a plurality of first signal terminals 10 arranged along a first direction D1 and a plurality of first signal lines 11 respectively connected to the plurality of first signal terminals 10. The plurality of first signal terminals 10 may be configured to provide a first power voltage signal to the pixel circuit 20 through the plurality of first signal lines 11. The first signal line 11 may extend along the second direction D2, the first direction D1 and the second direction D2 may intersect, and may be parallel to the light-emitting surface of the display panel.

The first signal terminal 10 may include a first group of signal terminals Z1 and a second group of signal terminals Z2. The number of first signal terminals 10 included in the second group of signal terminals Z2 may be greater than the number of first signal terminals 10 included in the first group of signal terminals Z1. Along the first direction D1, the first group of signal terminals Z1 may be located between the second group of signal terminals Z2 and the edge B1 of the display panel. The edge B1 may refer to the edge of the display panel extending along the second direction D2.

The pixel mentioned in the present disclosure may be embodied as a light-emitting element, specifically an inorganic light-emitting element (such as Mini LED or Micro LED, etc.) or an organic light-emitting element (such as OLED). The pixel circuit 20 connected to the pixel may include multiple transistors. The film layer structure shown in FIG. 3 only shows one transistor in the pixel circuit 20 connected to the same light-emitting element, and does not show other transistors in the pixel circuit 20. The pixel circuit 20 mentioned in the present disclosure may adopt the pixel circuit 20 in the related art, and may not be limited to this. Some feasible pixel circuits 20 will be illustrated in the following embodiments.

In one embodiment, the pixels mentioned in the present disclosure and the pixel circuits 20 connected to the pixels may be all located in the display area, and the pixel circuits 20 may be arranged in an array in the display area. FIG. 1 only illustrates the pixel circuit 20 in a rectangular structure, but the actual outline shape of the pixel circuit 20 and the actual area occupied by the pixel circuit 20 in the display panel are not limited in the present disclosure. It should be noted that FIG. 1 does not show the light-emitting element connected to the pixel circuit 20, and the connection relationship between the two may refer to FIG. 3 and subsequent embodiments.

The display panel of the present disclosure may be provided with a plurality of first signal terminals 10 arranged along the first direction D1, and each first signal terminal 10 may be electrically connected to the first signal line 11 respectively. The first signal terminal 10 may provide a first power voltage signal to the pixel circuit 20 through the first signal line 11 such that the pixel circuit 20 may generate a driving current for driving the pixel to emit light. To realize the normal light-emission of each pixel in the display panel, the first power voltage signal may need to be transmitted to each pixel circuit 20 in the display panel. Because different pixel circuits 20 may be distributed at different positions in the display area, when the first power voltage signal is transmitted from the first signal terminal 10 to the pixel circuit 20 through the first signal line 11, due to the existence of the impedance of the first signal line 11, the first power voltage signal may produce a voltage drop during the transmission process. For this reason, in the related art, the first signal terminal is usually set at the middle position of one side of the display area, and the power voltage signal is provided to the entire display area through the first signal terminal located at the middle position of the bottom side of the display area. However, this design method also has the problem that the power voltage signal strength near the first signal terminal is large, while the power voltage signal in the area far from the first signal terminal is significantly weakened, resulting the brightness in the display area near the first signal terminal is significantly higher than that of other display areas, which is also not conducive to improving the display brightness uniformity of the display product.

The present disclosure introduces a plurality of first signal terminals 10 in the display panel, and the first signal terminals 10 may include a first group of signal terminals Z1 arranged along the first direction D1 adjacent to the edge B1 of the display panel, and a second group of signal terminals Z2 arranged along the first direction D1 away from the edge B1 of the display panel. That is, the second group of signal terminals Z2 may be located at a side of a center line of the first group of signal terminals Z1 extending toward the display panel along the second direction D2. In other words, the first group of signal terminals Z1 may be located at a side of an edge B1 of the second group of signal terminals Z2 extending toward the display panel along the second direction D2. It should be noted that FIG. 1 and FIG. 2 respectively illustrate two different arrangement structures of the first signal terminals 10 included in the second group of signal terminals Z2 and the corresponding first signal lines 11, but the present disclosure is not limited to this. In the present disclosure, the number of first signal terminals 10 included in the second group of signal terminals Z2 may be greater than the number of first signal terminals 10 included in the first group of signal terminals Z1, and each first signal terminal 10 may be electrically connected to a different first signal line 11, and the first power voltage signal may be provided to the pixel circuits 20 in different display areas of the display panel through the first signal lines 11. In this way, it may be equivalent to introducing the first signal lines 11 connected to the first signal terminal 10 to both the area near the center line extending along the second direction D2 of the display panel and the area near the edge B1 extending along the second direction D2 of the display panel, and when providing the first power voltage signal to the pixel circuits 20 in the display area, each first signal terminal 10 in the first group of signal terminals Z1 and the second group of signal terminals Z2 may all transmit the first power voltage signal to the corresponding first signal line 11. Compared with the method of transmitting the power supply voltage signal only through one first signal terminal 10, the method of introducing multiple first signal terminals 10 and corresponding multiple first signal lines 11 in the present disclosure may be conducive to improving the transmission rate of the first power voltage signal and reducing the overall voltage drop of the first power supply voltage signal, thereby weakening or avoiding the display unevenness caused by the voltage drop problem of the first power voltage signal of the display panel. Accordingly, the overall display brightness uniformity of the display panel may be improved. Moreover, a small number of first signal terminals 10 may be set in the first group of signal terminals Z1 adjacent to the edge, and a large number of first signal terminals 10 may be set in the second group of signal terminals Z2 far from the edge, the first signal terminals 10 may be arranged as evenly as possible along the first direction D1 and to transmit the first power voltage signal to the corresponding first signal line 11, thereby reducing the display brightness difference between the display area around the first signal terminal 10 and other display areas, thereby improving the overall display brightness uniformity of the display panel.

It should be noted that FIG. 1 shows a solution in which a plurality of pixel circuit columns L are included between two first signal lines 11 corresponding to the second group of signal terminals Z2, and FIG. 2 shows a solution in which no pixel circuit column is included between two first signal lines 11 corresponding to the second group of signal terminals Z2, and the present disclosure is not limited thereto. The pixel circuit columns in FIG. 1 and FIG. 2 are only for illustration and do not represent the actual number. The number of pixel circuit columns L included between the first signal lines 11 corresponding to the first group of signal terminals Z1 and the second group of signal terminals Z2, and the number of pixel circuit columns included between the first signal lines 11 corresponding to the second group of signal terminals Z2 are also only for illustration, and the present disclosure is not limited thereto.

The embodiments shown in FIG. 1 and FIG. 2 are only described by taking the display panel including a second group of signal terminals Z2 as an example, but do not limit the number of second group of signal terminals Z2 actually included in the display panel. In some other embodiments of the present disclosure, the display panel may also include two or more second groups of signal terminals Z2. For example, as shown in FIG. 4, which is a structural schematic diagram of another exemplary display panel provided by the embodiment of the present disclosure, the number of the second group of signal terminals Z2 may be greater than the number of the first group of signal terminals Z1.

Specifically, the embodiment in FIG. 4 is described by taking the display panel including two first group of signal terminals Z1 and three second group of signal terminals Z2 as an example, but the present disclosure is not limited thereto. In some other embodiments of the present disclosure, the number of the second group of signal terminals Z2 may be more than three. In the present disclosure, the two first group of signal terminals Z1 may be respectively located on the side of the second group of signal terminals Z2 facing the edge B1 of the display panel. Because the number of first signal terminals 10 included in a single second group of signal terminals Z2 is greater than the number of first signal terminals 10 included in a single first group of signal terminals Z1, and the number of second signal terminals Z2 may be greater than the number of first group of signal terminals Z1, the total number of first signal terminals 10 included in the second group of signal terminals Z2 may be greater than the total number of first signal terminals 10 included in the first group of signal terminals Z1, which may be equivalent to introducing a larger number of first signal terminals 10 between the first signal terminals 10 corresponding to the first group of signal terminals Z1, and each first signal terminal 10 may be connected to the corresponding first signal line 11. The first power voltage signal may be provided to the pixel circuit 20 through a larger number of first signal terminals 10 and the corresponding first signal lines 11, the transmission efficiency of the first power voltage signal may be improved and the voltage drop in the transmission process of the first power voltage signal may be reduced, thereby weakening or avoiding the display unevenness of the display panel caused by the voltage drop problem of the first power voltage signal, and it may be conducive to improving the overall display brightness uniformity of the display panel.

Further, referring to FIG. 4, in one embodiment of the present disclosure, the first group of signal terminals Z1 may include one first signal terminal 10, and the second group of signal terminals Z2 may include two first signal terminals 10. Because the first group of signal terminals Z1 may be arranged at the side of the second group of signal terminals Z2 facing the edge B1 of the display panel, that is, the first group of signal terminals Z1 may be arranged closer to the edge B1 of the display panel, at this time, when one first signal terminal 10 is introduced into a single first group of signal terminals Z1, the requirement of providing the first power voltage signal to the pixel circuit 20 in the edge area of the display panel may be met. Considering that more pixel circuits 20 may be arranged in the non-edge area of the display area, the single second group of signal terminals Z2 may be set to include two first signal terminals 10, such that the first power voltage signal may be provided to more pixel circuits 20 in the non-edge area of the display area. Moreover, by increasing the number of the second group of signal terminals Z2, the number of first signal terminals 10 included in the second group of signal terminals Z2 as a whole may be further increased to use more first signal terminals 10 to provide the first power s voltage signal to the pixel circuits 20 in the non-edge area, thereby facilitating the improvement of the transmission rate of the first power voltage signal provided by each first signal terminal 10 to the pixel circuit 20, reducing the transmission voltage drop of the first power voltage signal, and facilitating the weakening or avoiding the display unevenness of the display panel caused by the voltage drop problem of the first power voltage signal, thereby further facilitating the improvement of the overall display brightness uniformity of the display panel.

Further, referring to FIG. 4, in one embodiment of the present disclosure, along the first direction D1, the distance S01 between the first signal lines 11 corresponding to the second group of signal terminals Z2 may be less than the distance S1 between the first signal line 11 corresponding to the first group of signal terminals Z1 and the first signal line 11 corresponding to the second group of signal terminals Z2. In an embodiment, along the first direction, a distance between any two adjacent first signal lines corresponding to the second group of signal terminals is less than a minimum distance between a first signal line corresponding to the first group of signal terminals and a first signal line corresponding to the second group of signal terminals. It should be noted that FIG. 4 only illustrates the distance between the first signal lines 11 corresponding to the adjacent first group of signal terminals Z1 and the second group of signal terminals Z2 in the display panel as an example, and the distance relationship between the first signal lines 11 corresponding to the non-adjacent first group of signal terminals Z1 and the second group of signal terminals Z2 may be applicable. The adjacent first group of signal terminals Z1 and the second group of signal terminals Z2 may refer to that no other second signal group of signal terminals Z2 may be disposed between the first group of signal terminals Z1 and the second group of signal terminals Z2; and the non-adjacent first group of signal terminals Z1 and the second group of signal terminals Z2 may refer to that at least one second group of signal terminals Z2 may be set between the first group of signal terminals Z1 and the second group of signal terminals Z2.

This embodiment is illustrated by taking a single first group of signal terminals Z1 including one first signal terminal 10 and a single second group of signal terminals Z2 including two first signal terminals 10 as an example. The two first signal terminals 10 in the second group of signal terminals Z2 may be respectively connected to different first signal lines 11. The distance between the two first signal lines 11 may be S01; the distance S1 between the first signal line 11 corresponding to the first group of signal terminals Z1 and the first signal line 11 corresponding to the second group of signal terminals Z2 may be regarded as the distance between the first signal line 11 corresponding to the first signal terminal 10 and the first signal line 11 in the second group of signal terminals Z2 that is closer to the first group of signal terminals Z1. In this embodiment, S01 <S1 may be set, which may be equivalent to arranging the first signal lines 11 corresponding to the second group of signal terminals Z2 more densely, that is, the first signal lines 11 providing the first power voltage signal to the pixel circuits 20 in the non-edge area may be arranged more densely. Because the number of pixel circuits 20 in the non-edge area may be relatively large, when the first power voltage signal is provided to this part of the pixel circuits 20 by arranging the first signal lines 11 more densely, it may be beneficial to improve the transmission rate of the first power voltage signal transmitted to this part of the pixel circuits 20, thereby facilitating the reduction of the voltage drop of the first power voltage signal, such that the first power voltage signal provided to each pixel circuit 20 may meet the preset requirements, thereby facilitating the improvement of the uniformity of the overall display brightness.

In one embodiment, referring to FIG. 4, the display panel may include two first group of signal terminals Z1, and the two first group of signal terminals Z1 may be located between the edge B1 of the display panel and the second group of signal terminals Z2. The first groups of signal terminals Z1 may be located in the area near the left edge and the right edge of the display panel, and the corresponding first signal lines 11 may also be set in the area near the left edge and the right edge. In this way, the first group of signal terminals Z1 and the corresponding first signal lines 11 may provide the first power voltage signal to the pixel circuits 20 near the edge area of the display panel to meet the demand for the first power voltage signal in the display area near the edge area of the display panel. Moreover, the first group of signal terminals Z1 and the second group of signal terminals Z2 may provide the first power voltage signal to the edge area and the non-edge area of the display area respectively, which may be conducive to reducing the transmission voltage drop of the first power supply signal and improving the overall display brightness uniformity of the display panel.

Further, referring to FIG. 4, the first group of signal terminals Z1 may include a first signal terminal 10, and the second group of signal terminals Z2 may include two first signal terminals 10, each of which may be electrically connected to a first signal line 11. In such a way, the display panel may be divided into at least two sub-display areas A0 arranged along the first direction D1 by the first signal lines corresponding to the first group of signal terminals Z1 and the second group of signal terminals Z2. The first signal line 11 connected to the first signal terminal 10 in the first group of signal terminals Z1 may be located between the edge of the display panel extending along the second direction D2 and the pixel circuit column adjacent to the edge. The first signal line 11 connected to the two first signal terminals 10 in the second group of signal terminals Z2 may be located between two adjacent sub-display areas A0. This arrangement of the first signal lines 11 corresponding to the first group of signal terminals Z1 and the second group of signal terminals Z2 may divide the display panel into a plurality of sub-display areas A0 arranged along the first direction D1. Moreover, the more sub-display areas A0 there are, the fewer pixel circuit columns there are in the sub-display areas A0, and the smaller the distance between the pixel circuit in the pixel circuit column and the first signal line 11 closest to it, which may be more conducive to improving the transmission rate of the first power supply signal and reducing the transmission voltage drop of the first power supply voltage signal. Accordingly, it may be conducive to improving the overall display brightness uniformity of the display panel.

In one embodiment, when the second group of signal terminals Z2 includes two first signal terminals 10, the first signal lines 11 corresponding to the two first signal terminals 10 in the second group of signal terminals Z2 may not include pixel circuits 20, that is, the two first signal lines 11 corresponding to the same second group of signal terminals Z2 may be located between two adjacent pixel circuit columns. In this way, the display panel may be divided into multiple sub-display areas A0 through the first signal lines 11 corresponding to the second group of signal terminals Z2, which may be conducive to reducing the distance between the pixel circuits in each pixel circuit column and the first signal line 11 closest to it, effectively reducing the number of pixel circuit columns corresponding to a single first signal line 11, and helping to reduce the load of the first signal line 11 and improve the rate of the first power supply signal transmitted by the first signal line 11. Accordingly, it may be conducive to reducing the voltage drop of the first power voltage signal and improving the overall display brightness uniformity of the display panel.

Further, referring to FIG. 2 and FIG. 4, in an optional implementation of the present disclosure, along the first direction D1, the minimum distance between the first signal line 11 corresponding to the first group of signal terminals Z1 and the first signal line 11 corresponding to the second group of signal terminals Z2 may be S1, the width of the display panel along the first direction D1 may be S0, S1/S0≤1/2. In one embodiment, in the implementation of the present disclosure, the first signal line 11 may extend along the second direction D2 and may be directly connected to the first signal terminal 10.

The above minimum distance S1 may refer to, in the first signal line 11 corresponding to the second group of signal terminals Z2, the first signal line 11 in the first group of signal terminals Z1 closest to the first signal line 11 corresponding to the first group of signal terminals Z1 and the first signal line 11 in the first group of signal terminal Z1, such as the distance between the first signal line 11-1 corresponding to the first group of signal terminal Z1 and the first signal line 11-2 corresponding to the second group of signal terminal Z2 in FIG. 2. In this embodiment, S1/S0≤1/2, that is, 2×S1≤S0, that is, among the first signal lines 11 corresponding to the second group of signal terminals Z2, at least one first signal line 11 may be located between the center line of the display panel extending along the second direction D2 and the first signal line 11 of the first group of signal terminals Z1. In other words, the left and right half-screen areas of the display panel may be provided with first signal lines 11 corresponding to the first group of signal terminals Z1 and first signal lines 11 corresponding to the second group of signal terminals Z2. These first signal lines 11 may be used to provide first power voltage signals to the pixel circuits 20 of the corresponding half-screen areas, respectively to improve the transmission rate of the first power supply voltage signals in the two half-screen areas of the display panel, reduce the voltage drop of the first power supply voltage signals, and improve the uniformity of the overall display brightness of the display panel. It should be noted that the center line of the display panel extending along the second direction D2 may be the central axis passing through the center point of the display panel and extending along the second direction D2. It is a virtual line, not a specific structure. The center line may be used to divide the display panel into two equal areas.

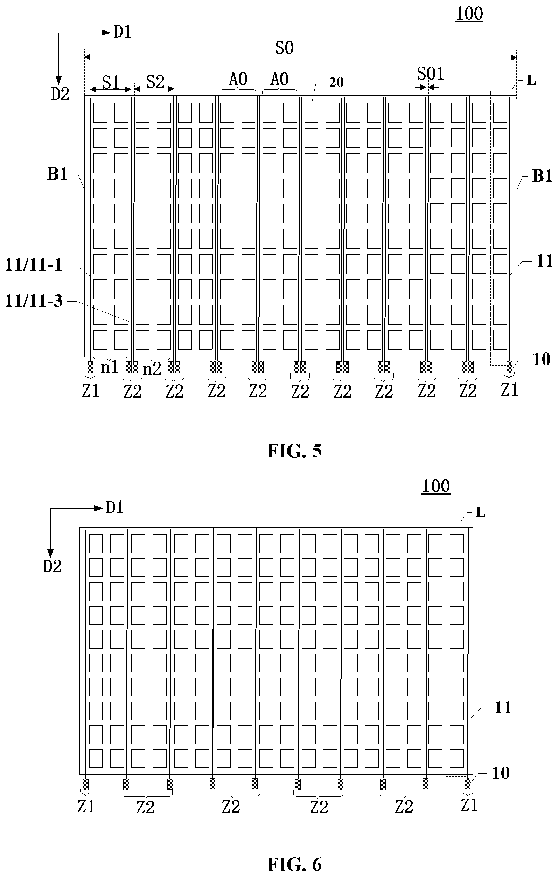

FIG. 5 is a schematic diagram of another exemplary display panel according to various embodiments of the present disclosure, which may be different from FIG. 1, FIG. 2 and FIG. 4 in that the number of the second group of signal terminals Z2 may be different. The number of the second group of signal terminals Z2 in the embodiment shown in FIG. 5 may be greater than the number of the second group of signal terminals Z2 in the embodiments shown in FIG. 1, FIG. 2 and FIG. 4. As shown in FIG. 5, in one embodiment of the present disclosure, along the first direction D1, the minimum distance between the first signal line 11 corresponding to the first group of signal terminals Z1 and the first signal line 11 corresponding to the second group of signal terminals Z2 may be S1, the width of the display panel along the first direction D1 may be S0, and S1/S0≤1/10.

The above minimum distance S1 may refer to, in the first signal line 11 corresponding to the second group of signal terminals Z2, the distance between the first signal line 11 in the first group of signal terminals Z1 closest to the first signal line 11 corresponding to the first group of signal terminals Z1 and the first signal lines 11 in the first group of signal terminals Z1, such as the distance between the first signal line 11-1 corresponding to the first group of signal terminals Z1 and the first signal line 11-3 corresponding to the second group of signal terminals Z2 in FIG. 5. In one embodiment, S1/S0≤1/10, that is, 10×S1≤S0.

When 10×S1=S0, it may be regarded as using the first signal line 11 corresponding to the first group of signal terminals Z1 and the second group of signal terminals Z2 to approximately evenly divide the display area in the display panel into ten sub-display areas A0 arranged along the first direction D1, and each display area may all include a corresponding first signal line 11 to provide a first power voltage signal to the pixel circuit 20 therein. When a single second group of signal terminals Z2 includes two first signal terminals 10, and each first signal terminal 10 may correspond to a first signal line 11, it may be equivalent to being able to set two first signal lines 11 for each of the ten sub-display areas A0, and the two first signal lines 11 may send the first power voltage signal to the sub-display area A0. The number of pixel circuits 20 included in a single sub-display area A0 may be relatively small, and the first power supply signal may be provided to these pixel circuits 20 via two first signal lines 11, which may be more conducive to improving the transmission rate of the first power voltage signal and reducing the voltage difference of the first power supply signal between the area close to the first signal terminal 10 and the area far from the first signal terminal 10 in the sub-display area A0, thereby facilitating the improvement of the display brightness uniformity of different areas in the sub-display area A0, and further facilitating the improvement of the display brightness uniformity of the entire display panel.

When 10×S1 < S0, it may be equivalent to using the first signal line 11 corresponding to the first signal terminal Z1 and the second signal terminal Z2 to divide the display area into more than ten sub-display areas A0, and when the second signal terminal Z2 includes two first signal terminals 10, it may still ensure that each sub-display area A0 may include two first signal lines 11 corresponding to it and provide the first power voltage signal to it, and the number of pixel circuits 20 in the sub-display area A0 corresponding to the two first signal lines 11 may be less, so it may be more conducive to improving the transmission rate of the first power supply voltage signal and reducing the voltage difference of the first power supply voltage signal received by different areas in the sub-display area A0. Accordingly, the display brightness uniformity of the sub-display area A0 may be further improved, and the overall display brightness uniformity of the display panel may be improved.

Further, referring to FIG. 4 and FIG. 5, in one embodiment of the present disclosure, the display panel may include at least two groups of second group of signal terminals Z2. Along the first direction D1, the minimum distance between the first signal lines 11 corresponding to two adjacent groups of second group of signal terminals Z2 may be S2, and the minimum distance between the first signal line 11 corresponding to the first signal terminal Z1 and the first signal line 11 corresponding to the second signal terminal Z2 may be S1, and S2=S1.

Specifically, the embodiment shown in FIG. 4 shows a solution in which the display panel includes three groups of second group of signal terminals Z2, and the embodiment shown in FIG. 5 shows a solution in which the display panel includes nine groups of second group of signal terminals Z2, but the number of second group of signal terminals Z2 actually included in the display panel is not limited. Among them, along the first direction D1, the minimum distance between the first signal line 11 corresponding to the first group of signal terminal Z1 and the first signal line 11 corresponding to the second group of signal terminal Z2 may be S1, and the minimum distance S1 may refer to, among the first signal lines 11 corresponding to the second group of signal terminals Z2, the distance between the first signal line 11 closest to the first signal line 11 corresponding to the first signal terminal Z1 in the first group of signal terminal Z1 and the first signal line 11 in the first group of signal terminal Z1. Along the first direction D1, the minimum distance between the first signal lines 11 corresponding to two adjacent groups of second group of signal terminals Z2 may be S2. The minimum distance S2 refers to, among the first signal lines 11 corresponding to the adjacent second signal terminals Z2, the distance between the two first signal lines 11 corresponding to different second groups of signal terminals Z2 and the closest to each other. In one embodiment, S1=S2 may be set, which may be equivalent to the number of pixel circuit columns contained between the first signal lines 11 corresponding to the first group of signal terminal Z1 and the second group of signal terminal Z2 adjacent thereto, and the number of pixel circuit columns contained between the first signal lines 11 corresponding to the two adjacent second groups of signal terminals Z2 may be same, that is, the display panel may be divided into multiple sub-display areas A0 by multiple first signal lines 11, and the number of pixel circuit columns included in each sub-display area A0 may be same, and each sub-display area A0 may correspond to two first signal lines 11 to transmit the first power voltage signal to the pixel circuit 20 in the sub-display area A0. In this way, it may be beneficial to improve the transmission rate of the first power voltage signal, and the transmission rate of the first power voltage signal in different sub-display areas A0 may be consistent or nearly consistent, which may be beneficial to reduce the display brightness difference corresponding to different sub-display areas A0 and improve the overall display brightness uniformity of the display panel.

In one embodiment, the distances between adjacent second group of signal terminals Z2 may be equal. It should be noted that the equal distances mentioned in the present disclosure may refer to the distance values being equal within the allowable range of error (±5%). The distance between adjacent second group of signal terminals Z2 mentioned in this embodiment may be regarded as the distance between two first signal terminals 10 that are closer in the adjacent second group of signal terminals Z2, that is, the width of the interval between two adjacent second group of signal terminals Z2. In this embodiment, the two first signal terminals 10 corresponding to the second group of signal terminals Z2 may be located between two adjacent sub-display areas A0, and the corresponding two first signal lines 11 may also be located between two adjacent sub-display areas A0. When the distances between adjacent second groups of signal terminals Z2 are equal, the widths of the multiple sub-display areas A0 formed by the first signal lines 11 corresponding to different second groups of signal terminals Z2 may be equal, that is, the number of pixel circuit columns included in each sub-display area A0 may be equal. In this way, the display panel may be equally divided into a plurality of sub-display areas A0 and each sub-display area A0 may include two corresponding first signal lines 11 to provide the first power voltage signal thereto, which may be conducive to reducing the load of each first signal line 11, and the load of each first signal line 11 may be same or nearly same. Thus, it may be conducive to reducing the voltage drop of the first power voltage signal transmitted on the first signal line 11, and further conducive to improving the overall display brightness uniformity of the display panel.

Further, referring to FIG. 4 and FIG. 5 in one embodiment of the present disclosure, the first signal line 11 connected to the first group of signal terminals Z1 may be located between the first edge B1 of the display panel and the first signal line 11 connected to the second group of signal terminals Z2, and the pixel circuit 20 is not included between the first signal line 11 and the first edge, and the first edge B1 may extend along the second direction D2. That is, in this embodiment, the first signal line 11 corresponding to the first group of signal terminals Z1 may be located at the periphery of the pixel circuit column along the first direction D1, and the pixel circuit column may be located at one side of the first signal line 11 along the first direction D1, and the other side may be the first edge B1 of the display panel. In this way, the first power voltage signal transmitted by the first signal line 11 corresponding to the first group of signal terminals Z1 may be provided to the pixel column adjacent to the first edge B1 at the first time, avoiding the problem of uneven brightness of the edge and non-edge of the display area caused by excessive voltage drop of the first power supply voltage signal transmitted to the pixel circuit column located in the edge area. In addition, when the first signal line 11 corresponding to the first group of signal terminals Z1 is set to be adjacent to the first edge B1 of the display panel, the first signal line 11 corresponding to the first group of signal terminals Z1 and the first signal line 11 corresponding to the second group of signal terminals Z2 may be used to divide the display area into multiple sub-display areas A0, and each sub-display area A0 may include two corresponding first signal lines 11 to transmit the first power voltage signal to it, which may be more conducive to reducing the transmission voltage drop of the first power voltage signal and improving the uniformity of the overall display brightness of the display panel.

Further, referring to FIG. 2, FIG. 4 and FIG. 5, in one embodiment of the present disclosure, the display panel may include N1 pixel circuit columns L arranged along the first direction D1, the minimum number of pixel circuit columns L included between the first signal line 11 connected to the first group of signal terminals Z1 and the first signal line 11 connected to the second group of signal terminals Z2 may be N2, and N2/N1 ≤ 1/2.

It should be noted that the pixel circuit columns L in the drawings of the present disclosure are only for illustration and do not limit the number of pixel circuit columns L actually included in the display panel. In this embodiment, the minimum number N2 of pixel circuit columns L included between the first signal line 11 corresponding to the first group of signal terminals Z1 and the first signal line 11 corresponding to the second group of signal terminals Z2 may refer to the number of pixel circuit columns L included between the first signal line 11 corresponding to the first group of signal terminals Z1 and the first signal line 11 that is closest to the first signal line 11 and corresponds to the second group of signal terminals Z2. In the present embodiment, N2/N1≤1/2, that is, 2×N2≤N1. When 2×N2=N1, it may be equivalent to using the first signal lines 11 corresponding to the first group of signal terminals Z1 and the second group of signal terminals Z2 to divide the display area into two sub-display areas A0. The number of pixel circuit columns L included in the two sub-display areas A0 may be same, and each sub-display area A0 may correspond to two first signal lines 11. The two first signal lines 11 may be located at both sides of the corresponding sub-display area A0 and provide the first power voltage signal to the sub-display area A0. This may be beneficial to balancing the loads of different first signal lines 11, reducing the voltage drop of the first power voltage signal transmission, and improving the display brightness uniformity of the display panel. When 2× N2<N1, it may be equivalent to using the first signal lines 11 corresponding to the first group of signal terminals Z1 and the second group of signal terminals Z2 to divide the display area into more than two sub-display areas A0, each sub-display area A0 may correspond to two first signal lines 11, and the number of pixel circuit columns L included in each sub-display area A0 may be relatively small. Using two first signal lines 11 to provide the first power voltage signal to the smaller number of pixel circuit columns L may be conducive to further improving the transmission rate of the first power voltage signal line, reducing the voltage drop of the first power supply voltage signal, and improving the overall display brightness uniformity of the display panel.

Further, referring to FIG. 5, in one embodiment of the present disclosure, the display panel may include N1 pixel circuit columns L arranged along the first direction D1, and the minimum number of pixel circuit columns L included between the first signal line 11 connected to the first group of signal terminals Z1 and the first signal line 11 connected to the second group of signal terminals Z2 may be N2, and N2/N1≤1/10.

It should be noted that the number of pixel circuit columns L set between the two first signal lines 11 in FIG. 5 is only for illustration and does not represent the actual number. In this embodiment, the minimum number N2 of pixel circuit columns L included between the first signal line 11 corresponding to the first group of signal terminals Z1 and the first signal line 11 corresponding to the second group of signal terminals Z2 may refer to the number of pixel circuit columns L included between the first signal line 11 corresponding to the first group of signal terminals Z1 and the first signal line 11 that is closest to the first signal line 11 and corresponds to the second group of signal terminals Z2. In this embodiment, N2/N1≤1/10, that is, 10×N2 ≤N1. When 10×N2=N1, it may be equivalent to using the first signal lines 11 corresponding to the first group of signal terminals Z1 and the second group of signal terminals Z2 to equally divide the display area into ten sub-display areas A0 arranged along the first direction D1. The number of pixel circuit columns L included in each sub-display area A0 may be same, and each sub-display area A0 may include two first signal lines 11 corresponding to it. When the display area is equally divided into ten sub-display areas A0, the number of pixel circuit columns L contained in each sub-display area A0 may be further reduced. When the first power supply signal is provided to the sub-display area A0 with fewer pixel circuit columns L through two first signal lines 11, the number of pixel circuit columns L connected to each first signal line 11 may be smaller, which may be equivalent to reducing the load of the first signal line 11, and which may be more conducive to improving the transmission rate of the first power voltage signal and reducing the voltage difference of the first power voltage signal between the area close to the first signal terminal 10 and the area far from the first signal terminal 10 in the sub-display area A0, thereby facilitating the improvement of the display brightness uniformity of different areas in the sub-display area A0, and further facilitating the improvement of the display brightness uniformity of the entire display panel.

When 10 ×N2<N1, it may be equivalent to using the first signal line 11 corresponding to the first group of signal terminals Z1 and the second group of signal terminals Z2 to divide the display area into more than ten sub-display areas A0. The more sub-display areas A0 formed by the division, the fewer pixel circuit columns L contained in each sub-display area A0 may be, the fewer pixel circuit columns L driven by each first signal line 11 will be, and the smaller the load of the first signal line 11 will be. Therefore, the voltage drop of the first power voltage signal transmitted through the first signal line 11 may be smaller, which may be more conducive to weakening or avoiding the problem of uneven display brightness caused by the large voltage drop of the first power voltage signal, thereby helping to improve the overall display brightness uniformity of the display panel. Moreover, when the second group of signal terminals Z2 includes two first signal terminals 10, it may be still possible to ensure that each sub-display area A0 includes two first signal lines 11 corresponding thereto and provide the first power voltage signal thereto, and the number of pixel circuits 20 in the sub-display area A0 corresponding to the two first signal lines 11 may be smaller, which may be more conducive to improving the transmission rate of the first power voltage signal and reducing the voltage difference of the first power voltage signal received by different areas in the sub-display area A0, thereby being more conducive to improving the display brightness uniformity of the sub-display area A0, and further being more conducive to improving the overall display brightness uniformity of the display panel.

Further, referring to FIG. 4 and FIG. 5, in one embodiment of the present disclosure, the display panel may include a plurality of pixel circuit columns L arranged along the first direction D1, and the display panel may include at least two groups of second groups of signal terminals Z2. Along the first direction D1, in the adjacent first group of signal terminals Z1 and the second group of signal terminals Z2, the minimum number of pixel circuit columns L included between the first signal line 11 connected to the first group of signal terminals Z1 and the first signal line 11 connected to the second group signal terminals Z2 may be n1, in the adjacent second groups of signal terminals Z2, the number of pixel circuit columns L included between the first signal lines 11 respectively connected to the two second groups of signal terminals Z2 may be n2, and n1=n2.

It should be noted that the pixel circuit columns L in the drawings of the present disclosure are only for illustration and do not limit the number of pixel circuit columns L actually included in the display panel. In this embodiment, the minimum number n1 refers to the number of pixel circuit columns L included between the first signal lines 11 corresponding to the adjacent first groups of signal terminals Z1 and second group of signal terminals Z2. Along the first direction D1, if no other second group of signal terminals Z2 are provided between the first group of signal terminals Z1 and the second group of signal terminals Z2, the two may be considered to be adjacent. Along the first direction D1, if no other second group of signal terminals Z2 are introduced between the two second groups of signal terminals Z2, the two second groups of signal terminals Z2 may be considered to be adjacent. In this embodiment, the number n1 of pixel circuit columns L between the first signal lines 11 corresponding to the first group of signal terminal Z1 and the adjacent second group of signal terminals Z2 may be same as the number of pixel circuit columns L between the first signal lines 11 corresponding to the two adjacent second groups of signal terminals Z2. In this way, the display area may be divided into a plurality of sub-display areas A0 arranged along the first direction D1 by using the first signal lines 11 corresponding to the first group of signal terminals Z1 and the second group of signal terminals Z2. The number of pixel circuit columns L included in each sub-display area A0 may be equal, and each sub-display area A0 may include two first signal lines 11 corresponding thereto. This may be conducive to improving the transmission rate of the first power voltage signal and reducing the voltage difference of the first power voltage signal received by different areas in the sub-display area A0, thereby further improving the display brightness uniformity of the sub-display area A0, and further improving the overall display brightness uniformity of the display panel.

The embodiment shown in FIG. 1 shows a scheme in which a pixel circuit column L is included between two first signal lines 11 corresponding to the second group of signal terminals Z2. The embodiments shown in FIG. 4 and FIG. 5 show a scheme in which a pixel circuit column is not included between two first signal lines 11 corresponding to the second group of signal terminals Z2.

Further, referring to FIG. 4 and FIG. 5, in one embodiment of the present disclosure, in the second group of signal terminals Z2, at least two first signal terminals 10 connected to the first signal lines 11 may not include a pixel circuit 20. That is, the first signal lines 11 corresponding to the two first signal terminals 10 in the second group of signal terminals Z2 may be located between two adjacent pixel circuit columns L. In this way, the display area may be divided into at least two sub-display areas A0 arranged along the first direction D1 by the first signal line 11. The two first signal lines 11 in the same second group of signal terminals Z2 may correspond to two adjacent sub-display areas A0 respectively, and provide the first power voltage signal to the adjacent sub-display areas A0 respectively. In this way, each sub-display area A0 may include two first signal lines 11 corresponding thereto and may provide the first power voltage signal thereto, which may be beneficial to reducing the load of a single first signal line 11, improving the transmission rate of the first power voltage signal, and thus may be beneficial to reducing the voltage drop of the first power supply voltage signal, and may be beneficial to improving the overall display brightness uniformity of the display panel.

FIG. 6 shows a structural schematic diagram of another exemplary display panel according to various embodiments of the present disclosure. The difference from the embodiments shown in FIG. 4 and FIG. 5 may include that the arrangement of the first signal lines 11 corresponding to the first signal terminals 10 in the same second group of signal terminals Z2 may be different. As shown in FIG. 6, in one embodiment of the present disclosure, in the second group of signal terminals Z2, a pixel circuit 20 may include between the first signal lines 11 connected to at least two first signal terminals 10.

Specifically, the embodiment of FIG. 6 shows a solution in which the display panel includes four second groups of signal terminals Z2, and each second group of signal terminals Z2 may include two first signal terminals 10, but the present disclosure is not limited thereto. In this embodiment, at least one pixel circuit column L may be included between two first signal lines 11 corresponding to the same second group signal terminals Z2, and the first signal lines 11 may not appear in pairs in the interval between two adjacent pixel circuit columns L. At this time, a single first signal line 11 may simultaneously provide a first power voltage signal to the pixel circuits 20 in the display area located at both sides thereof. In one embodiment, the number of pixel circuit columns L included between two first signal lines 11 corresponding to the same second group of signal terminals Z2, the minimum number of pixel circuit columns L included between the first signal lines 11 corresponding to the adjacent second groups of signal terminals Z2, and the minimum number of pixel circuit columns L included between the first group of signal terminals Z1 and the first signal line 11 corresponding to the adjacent second group of signal terminals Z2 may all be same. For example, FIG. 6 shows that the above numbers are all two. In this way, the first signal lines 11 may be evenly arranged in the display panel, and the first signal terminals 10 corresponding to the first group of signal terminals Z1 and the second group of signal terminals Z2 may be arranged as evenly as possible in the display panel. When the first power supply signal is provided to the pixel circuit columns L in different areas of the display panel by the evenly arranged first signal terminals 10 and the evenly arranged first signal lines 11, it may be beneficial to improve the transmission rate of the first power voltage signal and reduce the voltage drop during the transmission process of the first power voltage signal, and it may also be beneficial to improve the display brightness uniformity of the display panel.

Further, referring to FIG. 5, in one embodiment of the present disclosure, the second group of signal terminals Z2 may include two first signal terminals 10, and the distance S01 between the first signal lines 11 connected to the two first signal terminals 10 in the second group of signal terminals Z2 along the first direction D1 may be less than 625µm.

In the manufacturing process of the display panel, two adjacent pixel circuit columns L may usually be separated by a gap. To avoid short circuits in adjacent pixel circuit columns L, the width of the above gap may be set to be greater than or equal to 625µm. To improve the screen ratio of the display panel, the width of the above gap may be set to be equal to approximately 625µm. In the present disclosure, when the second group of signal terminals Z2 includes two first signal terminals 10, the first signal line 11 connected to the first signal terminal 10 may be arranged in the interval between the pixel circuit columns L. In this embodiment, the distance between the two first signal lines 11 corresponding to the two first signal terminals 10 may be limited to less than 625µm, which may be equivalent to setting the first signal lines 11 connected to the two first signal terminals 10 in the same second group of signal terminals Z2 in the same pixel column interval, that is, in the second group of signal terminals Z2, the pixel circuit 20 may not be included between the first signal lines 11 corresponding to the two first signal terminals 10. In this way, the display panel may be divided into a plurality of sub-display areas A0 by the first signal lines 11 corresponding to the first group of signal terminals Z1 and the second group of signal terminals Z2, and each sub-display area A0 may all include two first signal lines 11 corresponding thereto and providing the first power voltage signal thereto, that is, each sub-display area A0 may include an exclusive first signal line 11 to provide the first power voltage signal thereto, which may effectively improve the rate of providing the first power supply voltage signal to the corresponding sub-display area A0 by the first signal line 11, thereby facilitating the reduction of the transmission voltage drop of the first power voltage signal, and further facilitating the reduction or avoidance of the display unevenness of the display panel caused by the voltage drop problem of the first power supply voltage signal, and thus facilitating the improvement of the overall display brightness uniformity of the display panel.

Further, referring to FIG. 5, the display panel may include two first groups of signal terminals Z1, and the two first group of signal terminals Z1 may be located between the edge B1 of the display panel and the second group of signal terminals Z2. That is to say, the two first group of signal terminals Z1 may be located in the area near the left edge and the right edge of the display panel, and the corresponding first signal line 11 may also be set in the area near the left edge and the right edge. In this way, the first group of signal terminals Z1 and the corresponding first signal lines 11 may provide the first power voltage signal to the pixel circuit 20 near the edge area of the display panel to meet the demand for the first power voltage signal in the display area near the edge area of the display panel. Moreover, the first group of signal terminals Z1 and the second group of signal terminals Z2 may provide the first power voltage signal to the edge area and the non-edge area of the display area respectively, which may be conducive to reducing the transmission voltage drop of the first power supply voltage signal and improving the uniformity of the overall display brightness of the display panel.

Further, referring to FIG. 5, in one embodiment, the first group of signal terminals Z1 may include a first signal terminal 10, and the second group of signal terminals Z2 may include two first signal terminals 10, each of which may be electrically connected to a first signal line 11. The first signal line 11 connected to the first signal terminal 10 in the first group of signal terminals Z1 may be located between the edge of the display panel extending along the second direction D2 and the pixel circuit column adjacent to the edge. The first signal line 11 connected to the two first signal terminals 10 in the second group of signal terminals Z2 may be located between two adjacent sub-display areas A0. This arrangement of the first signal lines 11 corresponding to the first group of signal terminals Z1 and the second group of signal terminals Z2 may divide the display panel into a plurality of sub-display areas A0 arranged along the first direction D1. Each sub-display area A0 may correspond to two first signal lines 11 providing the first power voltage signal thereto, and the first signal lines 11 corresponding to each sub-display area A0 may be different. This may be conducive to reducing the number of pixel circuit columns corresponding to each first signal line 11 and reducing the load of the first signal line 11, thereby facilitating the improvement of the transmission rate of the first power voltage signal line and reducing the transmission voltage drop of the first power voltage signal, thereby facilitating the improvement of the overall display brightness uniformity of the display panel.

Further, referring to FIG. 4 and FIG. 5, in one embodiment of the present disclosure, the number of the second group of signal terminals Z2 may be Q, Q≥3, and Q may be an odd number. Specifically, this embodiment shows a solution in which two first groups of signal terminals Z1 may be introduced into the display panel and the first signal lines 11 connected to the first group of signal terminals Z1 may be respectively adjacent to two edges of the display panel extending along the second direction D2. Among them, the number of the second group of signal terminals Z2 may be greater than the number of the first group of signal terminals Z1, and the number of the second groups of signal terminals Z2 may be an odd number greater than or equal to 3. In one embodiment, the two first signal lines 11 corresponding to the same second group of signal terminals Z2 may be located in the same pixel column interval. In this way, the display area may be divided into an even number of sub-display areas A0 using the first signal lines 11 in the first group of signal terminals Z1 and the second group of signal terminals Z2. When Q=3, the number of sub-display areas A0 formed by division may be 4, and when Q>3, the number of sub-display areas A0 formed by division may be an even number greater than 4. In this embodiment, each sub-display area A0 may include two exclusive first signal lines 11 to provide the first power voltage signal thereto, which may effectively improve the transmission rate of the first power voltage signal in each sub-display area A0, help to reduce the voltage drop of the first power voltage signal, and thus help to improve the uniformity of the display brightness of the display panel as a whole.

In one embodiment, the number Q of the second group of signal terminals Z2 included in the display panel may be 9. When Q=9, referring to FIG5, which may be equivalent to dividing the display panel into ten sub-display areas A0 arranged along the first direction D1. The more sub-display areas A0 formed by dividing the display panel using the first group of signal terminals Z1 and the first signal line 11 corresponding to the second group of signal terminals Z2, the fewer the number of pixel circuit columns included in each sub-display area A0 may be, and the fewer the number of pixel circuit columns driven by each first signal line 11 may be, and the smaller the load of the first signal line 11 may be. Accordingly, the voltage drop of the first power supply voltage signal transmitted by the first signal line 11 may be smaller, which may be more conducive to weakening or avoiding the problem of uneven display brightness caused by the large voltage drop of the first power voltage signal, thereby helping to improve the overall display brightness uniformity of the display panel.

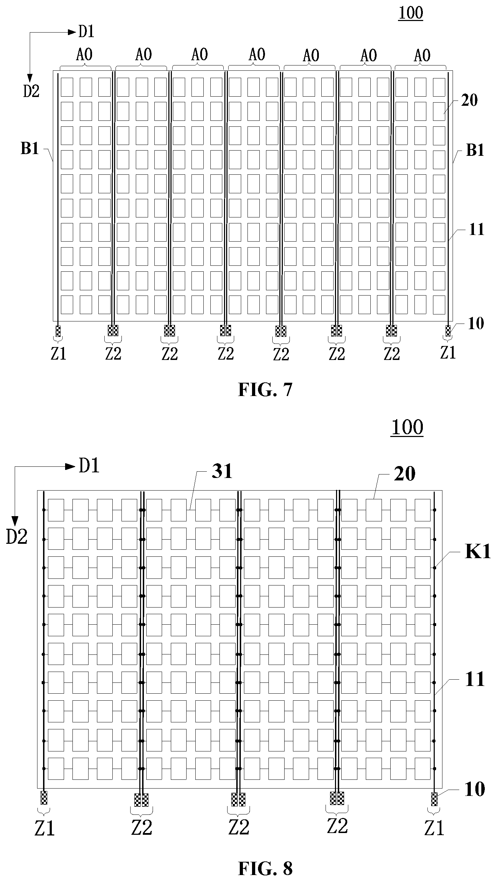

FIG. 7 shows a structural schematic diagram of another exemplary display panel according to various embodiments of the present disclosure, which may differ from the aforementioned embodiments at least in that the number of the second group of signal terminal Z2 included in the display panel may be different and the number of pixel circuit columns included in the sub-display area A0 may be different. As shown in FIG. 7, in one embodiment of the present disclosure, the display area may include N sub-display areas A0 arranged along the first direction D1 and having equal widths, and the second group of signal terminals Z2 may be located between the n-th sub-display area A0 and the (n+1)-th sub-display area A0, wherein 1≤ n≤N-1. It should be noted that the equal width mentioned in the present disclosure may refer to the width values being equal within the allowable range of error (±5%).

Specifically, the present embodiment may divide the display area into N sub-display areas A0 arranged along the first direction D1, and the widths of the sub-display areas A0 may be equal, that is, the number of pixel circuit columns inlcuded in each sub-display area A0 may be the same, which may be equivalent to dividing the display area into equal parts. When the second group of signal terminals Z2 is introduced into the display panel, the second group of signal terminals Z2 may be set in the area between two adjacent sub-display areas A0. For example, when the second group of signal terminals Z2 include two first signal terminals 10, the two first signal terminals 10 in the second group of signal terminals Z2 may be both located between two adjacent sub-display areas A0, and the first signal line 11 connected to the two first signal terminals 10 may also be located between the corresponding two adjacent sub-display areas A0. In this way, the two first signal lines 11 corresponding to the same second group of signal terminals Z2 may transmit the first power supply voltage signal to different sub-display areas A0 respectively, such that each sub-display area A0 may include two first signal lines 11 corresponding to it and transmitting the first power voltage signal to it, which may be conducive to reducing the number of pixel circuit columns connected to each first signal line 11 and reducing the load of the first signal line 11, thereby helping to reduce the voltage drop of the first power voltage signal transmitted through the first signal line 11, and helping to improve the overall display brightness uniformity of the display panel.

It should be noted that the relative position relationship between the first signal terminal and the first signal line corresponding thereto in the embodiment of the present disclosure is only for illustration. In the scheme currently shown, the first signal terminal may be located directly below the first signal line connected thereto along the second direction D2, and this method may easily realize the electrical connection between the two. Of course, in some other embodiments of the present disclosure, at least a portion of the first signal terminal may not be located directly below the corresponding first signal line, and the two may be connected through a fan-out line (curve or broken line), and the present disclosure does not limit this. In some other embodiments of the present disclosure, all the first signal terminals may not be located directly below the corresponding first signal line.

In one embodiment of the present disclosure, for example, referring to FIG. 5, the number of sub-display areas A0 included in the display area may be N=10. The more sub-display areas A0 are divided, the fewer pixel circuit columns each sub-display area A0 may include, the smaller the distance between each pixel circuit column and the first signal line 11 closest to it, the fewer pixel circuit columns driven by each first signal line 11, and the smaller the load of the first signal line 11. Therefore, the voltage drop of the first power voltage signal transmitted through the first signal line 11 may be smaller, which may be more conducive to weakening or avoiding the problem of uneven display brightness caused by the large voltage drop of the first power supply voltage signal. Therefore, when the number of sub-display areas A0 is 10, it may be more conducive to improving the uniformity of the overall display brightness of the display panel.

Further, referring to FIG. 5 and FIG. 7, in one embodiment of the present disclosure, the display panel may include two first groups of signal terminals Z1, and the first groups of signal terminals Z1 may be located between the edge B1 of the display panel and the second group of signal terminals Z2.

Specifically, this embodiment shows that when the first groups of signal terminals Z1 are introduced into the display panel, the first groups of signal terminals Z1 may be introduced at a position close to the left edge and a position close to the right edge of the display panel, respectively. When the display panel includes a plurality of second groups of signal terminals Z2, the first group of signal terminals Z1 may be located at the side of the edge of the display panel facing the plurality of second groups of signal terminals Z2. The left edge and the right edge of the display panel mentioned in this embodiment may all refer to the edge of the display panel extending along the second direction D2. That is to say, the first groups of signal terminals Z1 may be located in the areas close to the left edge and the right edge of the display panel, and the corresponding first signal lines 11 may also be set in the area close to the left edge and the right edge of the display panel. In this way, the first group of signal terminals Z1 and the corresponding first signal line 11 may provide the first power supply voltage signal to the pixel circuit 20 close to the edge area of the display panel, thereby meeting the demand for the first power voltage signal in the display area close to the edge area of the display panel. Moreover, the first group of signal terminals Z1 and the second group of signal terminals Z2 may provide the first power voltage signal to the edge area and the non-edge area of the display area respectively, which may be conducive to reducing the transmission voltage drop of the first power voltage signal and improving the uniformity of the overall display brightness of the display panel.

Further, referring to FIG. 5 and FIG. 7, in one embodiment of the present disclosure, the first group of signal terminals Z1 may include a first signal terminal 10, and the second group of signal terminals Z2 may include two first signal terminals 10, each of which may be electrically connected to a first signal line 11. The first signal line 11 connected to the first signal terminal 10 in the first group of signal terminals Z1 may be located between the edge of the display panel extending along the second direction D2 and the pixel circuit column adjacent to the edge. The first signal line 11 connected to the two first signal terminals 10 in the second group of signal terminals Z2 may be located between two adjacent sub-display areas A0. This arrangement of the first signal lines 11 corresponding to the first group of signal terminals Z1 and the second group of signal terminals Z2 may divide the display panel into a plurality of sub-display areas A0 arranged along the first direction D1. Each sub-display area A0 may correspond to two first signal lines 11 providing the first power voltage signal thereto, and the first signal lines 11 corresponding to each sub-display area A0 may be different. This may be conducive to reducing the number of pixel circuit columns corresponding to each first signal line 11 and reducing the load of the first signal line 11, thereby facilitating the improvement of the transmission rate of the first power voltage signal line and reducing the transmission voltage drop of the first power voltage signal, thereby facilitating the improvement of the overall display brightness uniformity of the display panel.

Further, referring to FIG. 5 and FIG. 7, in one embodiment of the present disclosure, when the second group of signal terminals Z2 includes two first signal terminals 10, in the second group of signal terminals Z2, the first signal lines 11 corresponding to the two first signal terminals 10 may not include pixel circuits 20, that is, the two first signal lines 11 corresponding to the same second group of signal terminals Z2 may be located between two adjacent pixel circuit columns. In this way, the display panel may be divided into a plurality of sub-display areas A0 by the first signal lines 11 corresponding to the second group of signal terminals Z2, and the two first signal lines 11 corresponding to the same second group of signal terminals Z2 may respectively provide the first power voltage signal to different sub-display areas A0, thereby effectively reducing the number of pixel circuit columns corresponding to a single first signal line 11, which may be beneficial to reducing the load of the first signal line 11 and improving the rate of the first power voltage signal transmitted by the first signal line 11, so it may be beneficial to reduce the voltage drop of the first power voltage signal and improve the overall display brightness uniformity of the display panel.

Further, referring to FIG. 5 and FIG. 7, in one embodiment of the present disclosure, the distances between adjacent second groups of signal terminals Z2 may be equal. The distances between adjacent second groups of signal terminals Z2 mentioned in this embodiment may be regarded as the distance between two first signal terminals 10 that are closer in the adjacent second groups of signal terminals Z2, that is, the width of the interval between two adjacent second groups of signal terminals Z2. In this embodiment, the two first signal terminals 10 corresponding to the second groups of signal terminals Z2 may be located between two adjacent sub-display areas A0, and the corresponding two first signal lines 11 may also be located between two adjacent sub-display areas A0. When the distances between adjacent second groups of signal terminals Z2 are equal, the widths of the multiple sub-display areas A0 formed by the first signal lines 11 corresponding to different second groups of signal terminals Z2 may be equal, that is, the number of pixel circuit columns included in each sub-display area A0 may be equal. In this way, the display panel may be equally divided into a plurality of sub-display areas A0 and each sub-display area A0 may include two corresponding first signal lines 11 to provide the first power voltage signal thereto, which may be conducive to reducing the load of each first signal line 11, and the load of each first signal line 11 may be same or nearly the same. Thus, it may be conducive to reducing the voltage drop of the first power voltage signal transmitted on the first signal line 11, and further conducive to improving the overall display brightness uniformity of the display panel.

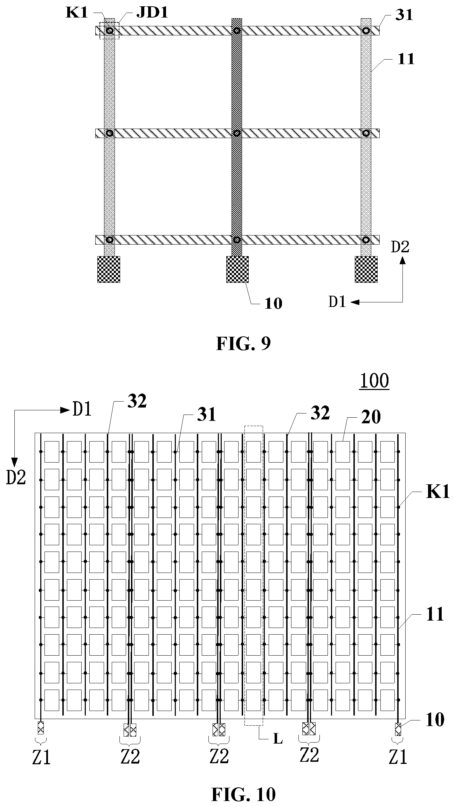

FIG. 8 is a structural schematic diagram of another exemplary display panel according to various embodiments of the present disclosure, and FIG. 9 is a connection schematic diagram of the first signal line 11 and the first connection line 31 in FIG. 8. As shown in FIG. 8 and FIG. 9, in one embodiment of the present disclosure, the display panel may further include a plurality of first connection lines 31 extending along the first direction D1 and arranged along the second direction D2. The first connection lines 31 and the first signal lines 11 may be arranged in different layers. The first connection lines 31 may be configured to transmit a first power voltage signal to the pixel circuit 20. In a direction perpendicular to the plane where the light-emitting surface of the display panel is located, the first signal line 11 and the first connection line 31 may overlap to form a plurality of first overlapping areas JD1. In the first overlapping areas JD1, the first signal line 11 and the first connection line 31 may be electrically connected through the first connection hole K1.

Specifically, referring to FIG. 8 and FIG. 9, after the first power supply voltage signal of the first signal terminal 10 is transmitted to the first signal line 11, it may be transmitted to the corresponding pixel circuit 20 through the first connection line 31 extending along the first direction D1. In this embodiment, when the first signal line 11 and the first connection line 31 are set in different film layers, it may be helpful to avoid the problem of short circuit between the first signal line 11 and other signal lines when the two are set in the same layer. When the first signal line 11 and the first connection line 31 are set in different film layers, along the direction perpendicular to the light-emitting surface of the display panel, the first signal line 11 and the first connection line 31 may have a first overlapping area JD1. The first signal line 11 and the first connection line 31 may be electrically connected in a portion of the first overlapping area JD1 through the first connection hole K1 such that the voltage on the first signal line 11 may be transmitted to the pixel circuit 20 through the first connection line 31.

In one embodiment, the first connection line 31 may extend from the left edge side of the display panel to the right edge side. In the direction perpendicular to the light-emitting surface of the display panel, the first connection line 31 may overlap with each first signal line 11 in the display panel to form a first overlapping area JD1. Each first overlapping area JD1 may be provided with a first connection hole K1. The first connection line 31 may be electrically connected to different first signal lines 11 through different first connection holes K1. In this way, multiple first signal lines 11 and multiple first connection lines 31 may form a grid structure, which may be conducive to reducing the overall impedance of the grid structure formed by the first signal lines 11 and the first connection lines 31, thereby facilitating the reduction of the voltage drop of the first power voltage signal transmitted on the first signal line 11, improving the problem of uneven display brightness of the display panel caused by the large voltage drop of the first power voltage signal line, and thus facilitating the improvement of the overall display brightness uniformity of the display panel.

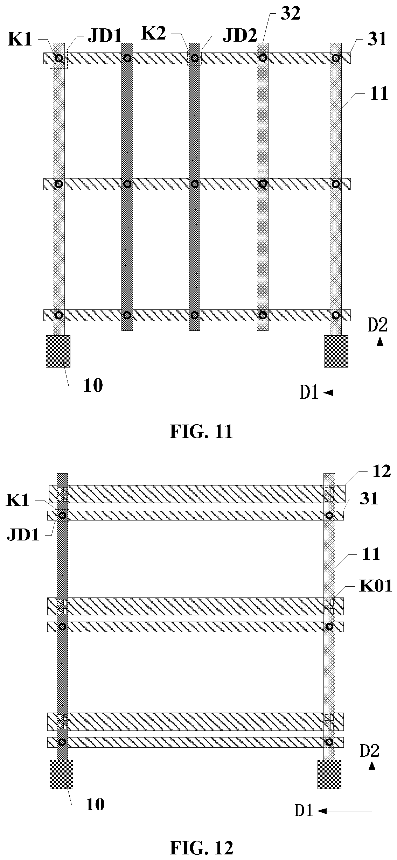

FIG. 10 is a structural schematic diagram of another exemplary display panel according to various embodiments of the present disclosure, and FIG. 11 is a connection schematic diagram of the first signal line 11, the first connection line 31 and the second connection line 32 in FIG. 10. As shown in FIG. 10 and FIG. 11, in one embodiment of the present disclosure, the display panel may also include a plurality of second connection lines 32 extending along the second direction D2 and arranged along the first direction D1, and the second connection lines 32 may be located between adjacent pixel circuit columns L. Along a direction perpendicular to the plane where the light-emitting surface of the display panel is located, the second connection lines 32 and the first connection lines 31 may overlap to form a plurality of second overlapping areas JD2, and in the second overlapping areas JD2, the first connection lines 31 and the second connection lines 32 may be electrically connected through second connection holes K2.

Further, referring to FIG. 10 and FIG. 11, this embodiment shows a solution of simultaneously introducing the first connection lines 31 and the second connection lines 32 into the display panel. The first connection lines 31 may extend along the first direction D1 and may be arranged along the second direction D2, the second connection lines 32 may extend along the second direction D2 and may be arranged along the first direction D1, and the extension direction and arrangement direction of the second connection lines 32 may be respectively same as the extension direction and arrangement direction of the first signal lines 11. In one embodiment, the second connection lines 32 may be arranged in the same layer as the first signal lines 11, and the second connection lines 32 and the first signal lines 11 may be manufactured in the same process without introducing different manufacturing processes and film layer structures, which may be conducive to simplifying the manufacturing process and film layer structure of the display panel. In some other embodiments of the present disclosure, the second connection lines 32 and the first signal lines 11 may also be arranged in different film layers, which is not limited by the present disclosure. The end of the first signal line 11 along the second direction D2 may be electrically connected to the first signal terminal 10 to obtain the first power voltage signal. The end of the second connection line 32 along the second direction D2 may not be electrically connected to the first signal terminal 10. The second connection line 32 may transmit the first power voltage signal by connecting to the first connection line 31.

In this embodiment, the second connection lines 32 and the first connection lines 31 may be located in different film layers. In a direction perpendicular to the plane where the light-emitting surface of the display panel is located, the second connection line 32 may overlap with the first connection line 31 to form a second overlapping area JD2. In the second overlapping area JD2, the second connection line 32 and the first connection line 31 may be electrically connected through the second connection hole K2. In this way, the signal line for transmitting the first power voltage signal in the display panel may include the first signal line 11, the first connection line 31 and the second connection line 32. The first signal line 11 and the second connection line 32 may extend along the second direction D2, and the first connection line 31 may extend along the first direction D1. The three may be interlaced horizontally and vertically, and a denser mesh structure for transmitting the first power voltage signal may be formed through the first connection hole K1 and the second connection hole K2 to be more conducive to reducing the overall impedance of the above-mentioned mesh structure, reducing the voltage drop of the first power voltage signal, and reducing the difference of the first power supply voltage signal obtained by the pixel circuit 20 in different areas of the display panel to be more conducive to improving the uniformity of the overall display brightness of the display panel.

Further, referring to FIG. 11, in one embodiment of the present disclosure, along the first direction D1, the width of the second connection line 32 may be greater than or equal to the width of the first signal line 11. When the width of the second connection line 32 is equal to the width of the first signal line 11, the second connection line 32 and the first signal line 11 may be made with the same width parameter to simplify the manufacturing process of the display panel. In one embodiment, the number of second connection lines 32 in the display panel may be greater than the number of first signal lines 11. The greater the number of second connection lines 32, the more it may be necessary to reduce their impedance to reduce the voltage drop of the first power voltage signal transmitted by them. When the display panel has space to set the second connection line 32 with a larger width, the width of the second connection line 32 may be set to be greater than the width of the first signal line 11. The larger the width of the second connection line 32, the smaller the impedance, which may be more conducive to reducing the overall impedance of the mesh structure composed of the first signal line 11, the first connection line 31 and the second connection line 32, thereby being more conducive to reducing the voltage drop of the first power supply voltage signal transmitted on the above-mentioned mesh structure, so as to further improve the overall display brightness uniformity of the display panel. In addition, setting the width of the second connection line 32 to be greater than the width of the first signal line 11 may be conducive to simplifying the wiring of the second connection line 32, thereby being conducive to simplifying the overall layout design.

FIG. 12 shows a relative position relationship diagram of the first signal line 11 and the second signal line 12 in the present disclosure. As shown in FIG. 12, in one embodiment of the present disclosure, the display panel may further include a plurality of second signal lines 12 extending along the first direction D1 and arranged along the second direction D2. The second signal line 12 may be configured to transmit a display control signal to the pixel circuit 20. The first signal line 11 may include a plurality of first openings K01. The first openings K01 may overlap with the second signal line 12 in a direction perpendicular to the plane where the light-emitting surface of the display panel is located.

The second signal line 12 mentioned in this embodiment may be, for example, a scanning line that provides a scanning signal to the pixel circuit 20, or a light-emitting control signal line that provides a light-emitting control signal to the pixel circuit 20. The signal transmitted on the second signal line 12 may be different from the signal transmitted on the first signal line 11. Therefore, when the first signal line 11 and the second signal line 12 overlap in a direction perpendicular to the plane where the light-emitting surface of the display panel is located, parasitic capacitance will be generated in the overlapping area. The existence of the parasitic capacitance may be likely to cause signal crosstalk. To this end, in this embodiment, a plurality of first openings K01 may be formed on the first signal line 11 such that the first openings K01 may overlap with the second signal line 12, which may be conducive to reducing the actual overlapping area of the first signal line 11 and the second signal line 12 to reduce the parasitic capacitance between the first signal line 11 and the second signal line 12, thereby facilitating the improvement of the stability of the signal transmitted on the second signal line 12.

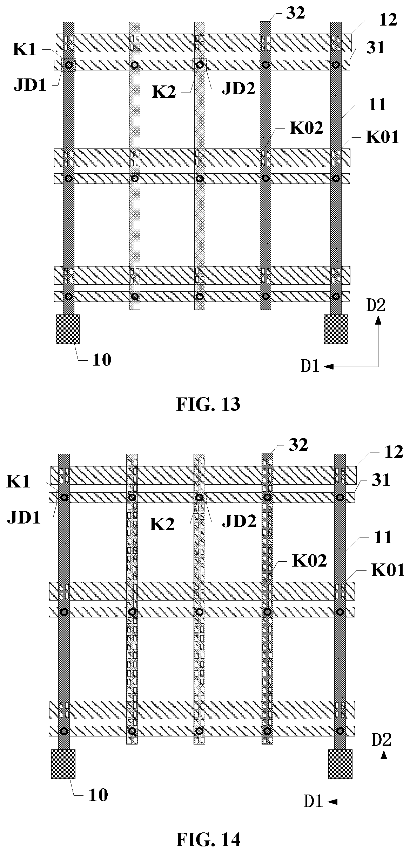

FIG. 13 shows an exemplary relative position relationship diagram of the first signal line 11, the second signal line 12 and the second connection line 32 in the present disclosure. When the display panel includes the first signal line 11, the second signal line 12 and the second connecting line 32 at the same time, the second signal line 12 may extend along the first direction D1, and the first signal line 11 and the second connecting line 32 may extend along the second direction D2. In the direction perpendicular to the plane where the light-emitting surface of the display panel is located, the second signal line 12 may overlap with the first signal line 11 and the second connection line 32 respectively. Therefore, in addition to introducing the first opening K01 on the first signal line 11, the second opening K02 may also be introduced on the second connection line 32. In the direction perpendicular to the plane where the light-emitting surface of the display panel is located, the first opening K01 and the second opening K02 may overlap with the second signal line 12 respectively. In this way, it may be beneficial to reduce the actual overlapping area of the first signal line 11 and the second signal line 12, and it may be beneficial to reduce the actual overlapping area of the second connection line 32 and the second signal line 12 to simultaneously reduce the parasitic capacitance between the first signal line 11 and the second signal line 12, and the parasitic capacitance between the second connection line 32 and the second signal line 12. Accordingly, it may be beneficial to improve the stability of the signal transmitted on the second signal line 12.

The embodiments shown in FIG. 12 and FIG. 13 only illustrate the first opening and the second opening through a rectangular structure, and do not limit the actual shape, size and number of the openings on the first signal line 11 and the second connection line 32. In some other embodiments of the present disclosure, the first opening K01 and the second opening K02 may also adopt other shapes, and the present disclosure is not limited thereto.

It should be noted that, in the embodiments shown in FIG. 12 and FIG. 13, the first opening K01 on the first signal line 11 may be only arranged in the region overlapping with the second signal line 12, and the second opening K02 on the second connection line 32 may only be arranged in the region overlapping with the second signal line 12. In the actual manufacturing process, the first signal line 11 as a whole or the second connection line 32 as a whole may also be arranged to have a structure with multiple openings. For example, please refer to FIG. 14, which is another exemplary relative position relationship diagram of the first signal line 11, the second signal line 12 and the second connection line 32 in the present disclosure. As shown in FIG. 14, in one embodiment, the first signal line 11 or the second connection line 32 may be arranged to have a plurality of openings. The second connection line 32 may be set as a grid structure including a plurality of second openings K02. That is, in addition to the area overlapping with the second signal line 12, the area on the second connection line 32 that does not overlap with the second signal line 12 may also be provided with a second opening K02. This may be conducive to ensuring that the second connection line 32 may have corresponding second openings K02 in most areas in the area overlapping with the second signal line 12, thereby facilitating the reduction of the actual overlapping area between the second connection line 32 and the second signal line 12. Accordingly, the parasitic capacitance between the second connection line 32 and the second signal line 12 may be effectively reduced. In some other embodiments of the present disclosure, the first signal line 11 may also be set as a grid structure similar to the second connection line 32 in the present embodiment to ensure that the parasitic capacitance between the first signal line 11 and the second signal line 12 may be effectively reduced, and the present disclosure does not specifically limit this.

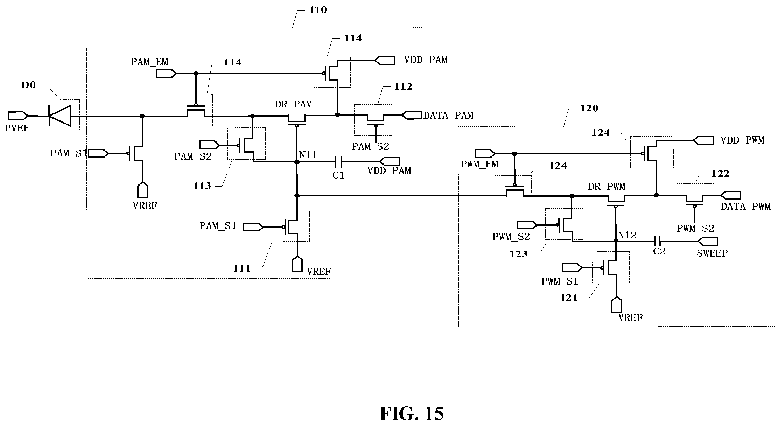

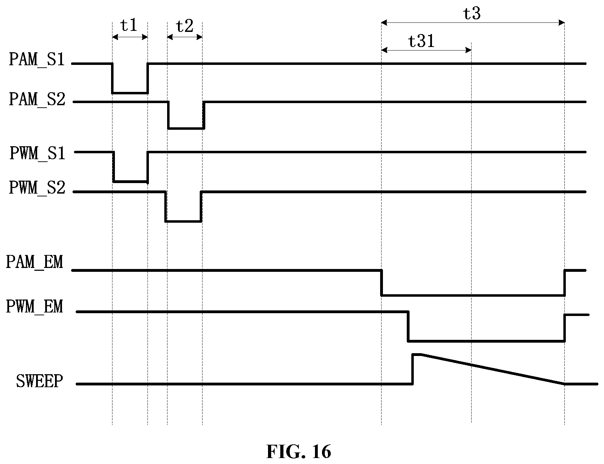

FIG. 15 shows a schematic diagram of an exemplary pixel circuit 20 provided in an embodiment of the present disclosure, and FIG. 16 shows a sequence diagram corresponding to FIG. 15. As shown in FIG. 15 and FIG. 16, in one embodiment of the present disclosure, the pixel circuit 20 may be configured to provide a driving current to the pixel. The pixel circuit 20 may include a pulse amplitude modulation circuit 110 and a pulse width modulation circuit 120. The pulse amplitude modulation circuit 110 may be configured to control the amplitude of the driving current based on the applied pulse amplitude modulation data, and the pulse width modulation circuit 120 may be configured to control the pulse width of the driving current. The pulse width modulation circuit 120 may include a first power supply terminal VDD_PWM, and the first power supply terminal VDD_PWM may be electrically connected to the first signal terminal 10 through the first signal line 11.

It should be noted that the pixel circuit 20 shown in FIG. 15 is only for illustration, and the present disclosure does not limit the actual structure of the pixel circuit 20. In some other embodiments of the present disclosure, any other feasible structure of the pixel circuit 20 may also be adopted. In the pixel circuit 20, the pulse width modulation circuit 120 may be electrically connected to the pulse amplitude modulation circuit 110, and the pulse amplitude modulation circuit 110 may be electrically connected to the light-emitting element. The first power supply terminal VDD_PWM of the pulse width modulation circuit 120 refers to the positive power supply voltage terminal of the pulse width modulation circuit 120.

Further, referring to FIG. 15 and FIG. 16, in one embodiment, the pulse amplitude modulation circuit 110 and the pulse width modulation circuit 120 may both include an initialization unit 111/121, a data writing unit 112/122, a threshold compensation unit 113/123, a light-emitting control unit 114/124, a storage capacitor C1/C2 and a driving transistor Dr_PAM/Dr_PWM (the pulse amplitude modulation circuit 110 may include an initialization unit 111, a data writing unit 112, a threshold compensation unit 113, a light-emitting control unit 114, a storage capacitor C1 and a driving transistor Dr_PAM; the pulse width modulation circuit 120 may include an initialization unit 111/121, a data writing unit 112, a threshold compensation unit 113, a light-emitting control unit 114, a storage capacitor C1 and a driving transistor Dr_PAM; and the pulse width modulation circuit 120 may include an initialization unit 111/121, a data writing unit 112, a threshold compensation unit 113, a light-emitting control unit 114, a storage capacitor C1 and a driving transistor Dr_PAM, a data writing unit 122, a threshold compensation unit 123, a light-emitting control unit 124, a storage capacitor C2 and a driving transistor Dr_PWM). The initialization unit 111/121 may be electrically connected between the initialization signal terminal VREF and the first node N11/N12, and the initialization unit 111/121 may be used for providing initialization signal of initialization signal terminal VREF to first node N11/N12 in initialization stage t1 (the value of initialization signal provided by initialization signal terminal of pulse amplitude modulation circuit 110 and the value of initialization signal provided by initialization signal terminal of pulse width modulation circuit 120 may be the same or different). The data writing unit 112/122 may be electrically connected between the data signal terminal DATA_PAM/DATA_PWM and the first electrode of the driving transistor Dr_PAM/Dr_PWM, and the gate of the driving transistor Dr_PAM/Dr_PWM and the first electrode plate of the storage capacitor C1/C2 may be electrically connected to the first node N11/N12. The data writing unit 112/122 may be used to provide the data voltage signal of the data signal terminal DATA _PAM/DATA_PWM to the first node N11/N12 through the driving transistor Dr_PAM/Dr_PWM during the data writing phase t2. The threshold compensation unit 113/123 may be electrically connected between the second electrode of the driving transistor Dr_PAM/Dr_PWM and the first node N11/N12, and the threshold compensation unit 113/123 may be used to compensate the threshold voltage of the driving transistor Dr_PAM/Dr_PWM to the first node N11/N12.

In the pulse width modulation circuit 120, the second plate of the storage capacitor C2 may be electrically connected to the frequency sweeping signal terminal SWEEP, and the frequency sweeping signal terminal SWEEP may receive the frequency sweeping signal. The light-emitting control unit 124 may be electrically connected between the first power supply terminal VDD_PWM and the first node N11 in the pulse amplitude modulation circuit 110. The light-emitting control unit 124 may be used to control the driving transistor Dr_PWM to generate a driving pulse in the light-emitting stage t3; the first power supply terminal VDD_PWM may receive the first power supply voltage signal VDD_PWM (here the same characters are used to represent the signal terminal and the signal provided by the signal terminal); and the data signal terminal DATA_PWM may receive the pulse width modulation data voltage DATA_PWM (here the same characters are used to represent the signal terminal and the signal provided by the signal terminal).

In the pulse amplitude modulation circuit 110, the second plate of the storage capacitor C1 may be electrically connected to the power supply signal terminal VDD_PAM, and the power supply signal terminal VDD_PAM may receive the second power supply voltage signal VDD_PAM (here the same characters are used to represent the signal terminal and the signal provided by the signal terminal). The light-emitting control unit 114 may be electrically connected between the power signal terminal VDD _PAM and the light-emitting element D0, the light-emitting control unit 114 may be used to control the driving transistor Dr_PAM to generate a driving current flowing into the light-emitting element D0 in the light-emitting stage to drive the light-emitting element D0 to emit light, and the data signal terminal DATA_PAM may receive the pulse amplitude modulation data voltage DATA_PAM (the same characters are used to represent the signal terminal and the signal provided by the signal terminal).

In one embodiment, the output terminal of the pulse width modulation circuit 120 may be electrically connected to the first node N11 of the pulse amplitude modulation circuit 110, and may be used to provide a control signal to the first node N11. Because the first node N11 may be electrically connected to the gate of the driving transistor Dr_PAM, it may be equivalent to providing a control signal to the gate of the driving transistor Dr_PAM. In the pulse width modulation circuit 120, when the voltage difference between the gate and the source of the driving transistor Dr_PWM is greater than the threshold voltage of the driving transistor Dr_PWM, the driving transistor Dr_PWM may be at the off state. At this time, the pulse width modulation circuit 120 may not provide a control signal to the first node N11 of the pulse amplitude modulation circuit 110, and the driving transistor Dr_PAM in the pulse amplitude modulation circuit 110 may provide a driving current to the light-emitting element according to the pulse amplitude modulation data voltage DATA_PAM. As the voltage of the sweep signal SWEEP changes, the gate potential of the driving transistor Dr_PWM may change synchronously until the voltage difference between the gate and the source of the driving transistor Dr_PWM is less than or equal to the threshold voltage of the driving transistor Dr_PWM, the driving transistor Dr_PWM may be turned on, and the driving transistor Dr_PWM may transmit the first power supply voltage signal VDD_PWM of the first power supply terminal VDD _PWM as the off voltage to the first node N11 of the pulse amplitude modulation circuit 110 such that the driving transistor Dr_PAM in the pulse amplitude modulation circuit 110 may be turned off, thereby stopping providing the driving current to the light-emitting element D0. It may be seen that the magnitude of the first power supply voltage signal VDD_PWM of the first power supply terminal VDD_PWM may directly determine its ability to turn off the driving transistor Dr_PAM in the pulse amplitude modulation circuit 100. The first power supply terminal VDD_PWM may obtain the first power supply voltage signal through the first signal line 11 and the first signal terminal 10.

In the related art, the voltage drop of the first power supply voltage signal is large in the area far from the first signal terminal 10, which reduces the turn-off capability of the driving transistor Dr_PAM in the pulse amplitude modulation circuit, thus causing the problem of uneven display. Therefore, the present disclosure may reduce the voltage drop of the first power voltage signal by introducing the first group of signal terminals Z1 and the second group of signal terminals Z2 and the corresponding first signal line 11 such that the first power supply voltage signal VDD _PWM transmitted to the pulse amplitude modulation circuit 110 in the pixel circuits of different regions tends to be consistent. Accordingly, the turn-off capability of the driving transistor Dr_PAM in the pulse amplitude modulation circuit 110 may tend to be consistent, and it may be beneficial to improve the overall display brightness uniformity of the display panel.

It should be noted that the driving circuit structure shown in FIG. 15 is an optional example of the present disclosure, and is not a limitation on the driving circuit of the display panel. For example, the pulse amplitude modulation circuit and the pulse width modulation circuit shown in FIG. 15 may both include a threshold compensation unit, which may be used to compensate the data signal for the threshold voltage of the driving transistor when writing the data signal into the circuit to ensure that the driving transistor may provide an accurate driving current and avoid being affected by the threshold voltage of the driving transistor when writing data. The embodiment of the present disclosure may also be applicable to a driving circuit structure without a threshold compensation unit. For example, the pulse amplitude modulation circuit and the pulse width modulation circuit shown in FIG. 15 may be adjusted as follows: the threshold compensation unit 113/123may be removed, and the connection mode of the data writing unit 112/122 may be adjusted to be connected between the data signal terminal DATA_PAM/DATA_PWM and the gate of the driving transistor Dr_PAM/Dr _PWM to provide the data voltage signal of the data signal terminal DATA_PAM/DATA_PWM to the first node N11/N12 through the data writing unit during the data writing stage. The present disclosure does not limit the specific structure of the pixel circuit.

In addition, to reduce the leakage current of other transistors in the pixel circuit 20 to the first node, the pulse amplitude modulation circuit and the pulse width modulation circuit shown in FIG. 15 may also be adjusted as follows: the initialization unit 111/121 and the threshold compensation unit 113/123 connected to the pulse amplitude modulation circuit 110 and the driving transistor Dr_PAM/Dr_PWM in the pulse width modulation circuit may be adjusted to transistors with a dual-gate structure or oxide transistors, etc.

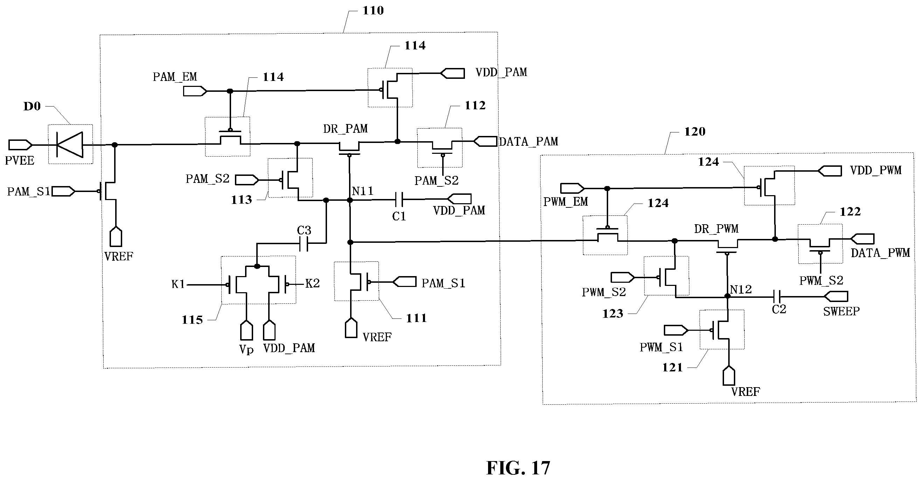

FIG. 17 shows a schematic diagram of another exemplary pixel circuit provided by the embodiment of the present disclosure. As shown in FIG. 17, the pulse amplitude modulation circuit 110 and the pulse width modulation circuit 120 may both include an initialization unit 111/121, a data writing unit 112/122, a threshold compensation unit 113/123, a light-emitting control unit 114/124, a storage capacitor C1/C2 and a driving transistor Dr_PAM/Dr_PWM, which may be same as the embodiment shown in FIG. 15, and the working principle may also refer to the relevant description of the embodiment shown in FIG. 15, which will not be repeated here. One of the differences between the embodiment shown in FIG. 17 and the embodiment shown in FIG. 15 may be that the pulse amplitude modulation circuit 110 in FIG. 17 may further include a capacitor C3 and a compensation module 115. The compensation module 115 may include two transistors, and the gates of the two transistors may be connected to the control signals K1 and K2, respectively. The first plate of the capacitor C3 may be connected to the first node N11, and the second plate may be connected to the compensation module 115. The compensation module 115 may be configured to write a reference voltage Vp to the second plate of the capacitor C3 during the first period of operation of the pulse amplitude modulation circuit 110, and to write a second power supply voltage signal VDD_PAM to the second plate of the capacitor C3 during the second period of operation of the pulse amplitude modulation circuit 110. In the working cycle of the pixel circuit, the first period and the second period may not overlap.

The compensation module 115 may write different voltages to the second plate of the capacitor C3 during different periods of operation of the pulse amplitude modulation circuit 110. For example, the second period may at least include the period of generating a driving current when the pulse amplitude modulation circuit 110 is operating (for example, the t31 period indicated in the timing diagram of FIG. 16), and the first period may be before the period of generating a driving current by the pulse amplitude modulation circuit 110. In one embodiment, the first period may include the initialization period t1 and/or the data writing stage t2 of the pulse amplitude modulation circuit 110.

In the initialization stage t1 of the pulse amplitude modulation circuit 110, the initialization unit 111 may be turned on to reset the gate of the driving transistor Dr_PAM. In the data writing stage t2 of the pulse amplitude modulation circuit 110, the data writing unit 112 and the threshold compensation unit 113 may be turned on, and the data signal DATA_PAM may be 0 written to the gate of the driving transistor Dr_PAM and threshold compensation is performed. The voltage of the gate of the driving transistor Dr_PAM is DATA_PAM-|Vth|, and the compensation module 30 writes the reference voltage Vp to the second plate of the capacitor C3.

In the actual light-emitting period t31 in the light-emitting stage t3, the compensation module 30 may write the second power supply voltage signal VDD_PAM to the second plate of the capacitor C3. When the voltage of the second plate of the capacitor C3 jumps from the reference voltage Vp to the second power supply voltage signal VDD_PAM, its voltage change may be VDD_PAM-Vp. Due to the coupling effect of the capacitor C3, the voltage at the gate of the driving transistor Dr_PAM may jump to DATA_PAM-|Vth|+VDD_PAM-Vp. During the actual light-emitting period, the light-emitting control unit 114 may be turned on, and the driving transistor Dr_PAM may generate a driving current under the control of its gate voltage. The calculation formula of the driving current may be: driving current Id=K*(Vgs-|Vth|)². Vgs may be the voltage difference between the gate and the source of the driving transistor. When applied to the driving transistor Dr_PAM, its gate voltage may be DATA_PAM-|Vth|+VDD_PAM-Vp, and its source voltage may be VDD_PAM, then Vsg=(DATA_PAM-|Vth|+VDD_PAM-Vp)-VDD_PAM-=DATA_PAM-|Vth|-Vp. Id=K×(DATA_PAM-Vp)². At this time, the driving current may be related to the data signal DATA_PAM and the reference voltage Vp, and may have nothing to do with the threshold voltage Vth and the second power supply voltage signal VDD_PAM. Thus, the compensation module 30 may be used to compensate for the deviation of the second power supply voltage signal VDD_PAM that affects the driving current such that the driving current may be no longer affected by the deviation of the second power voltage signal VDD_PAM, avoiding the deviation of the second power voltage signal VDD_PAM causing uneven display, and improving the display uniformity.

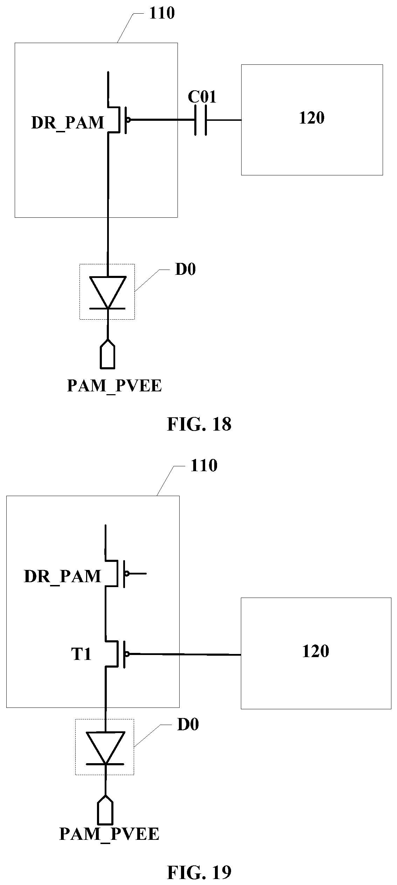

In the embodiments shown in FIG. 15 and FIG. 17, the output terminal of the pulse width modulation circuit 120 may be directly connected to the gate of the driving transistor Dr_PAM in the pulse amplitude modulation circuit 110. In some other embodiments of the present disclosure, the pulse width modulation circuit and the pulse amplitude modulation circuit may have some other connection relationships. Referring to FIGS. 18-20 below, some exemplary connection methods between the pulse amplitude modulation circuit 110 and the pulse width modulation circuit 120 are introduced. FIGS. 18-20 respectively show a connection schematic diagram of the pulse amplitude modulation circuit and the pulse width modulation circuit in the present disclosure.

As shown in FIG. 18, the pixel circuit may further include a connection capacitor C01, and the pulse width modulation circuit 120 may be connected to the gate of the driving transistor Dr_PAM in the pulse amplitude modulation circuit 110 through the connection capacitor C01.

Alternatively, as shown in FIG. 19, the pulse amplitude modulation circuit 110 may further include a first control transistor T1, and the first control transistor T1 may be connected between the driving transistor Dr_PAM and the light-emitting element D0. The output terminal of the pulse width modulation circuit 120 may be connected to the gate of the first control transistor T1.

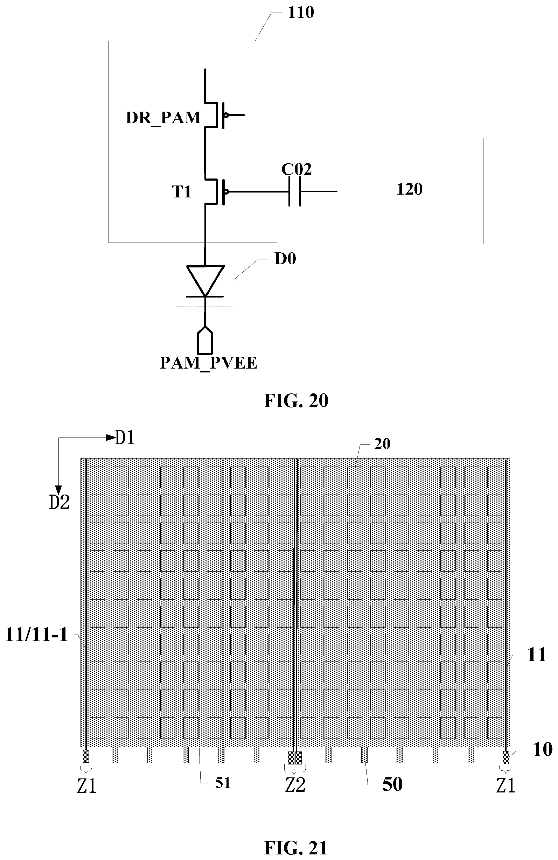

Alternatively, as shown in FIG. 20, the pixel circuit may further include a connection capacitor C02, and the output terminal of the pulse width modulation circuit 120 may be connected to the gate of the driving transistor Dr_PAM in the pulse amplitude modulation circuit 110 through the connection capacitor C02.

It should be noted that the structure of any one of the pulse amplitude modulation circuits 110 in the above embodiments may be combined with the structure of any one of the pulse width modulation circuits 120 in other embodiments. In addition, the pulse amplitude modulation circuit 110 and the pulse width modulation circuit 120 may be connected by any one of the connection methods in FIGS. 18-20. It should also be noted that other structures of the pulse amplitude modulation circuit 110, other structures of the pulse width modulation circuit 120, and other connection methods between the pulse amplitude modulation circuit 110 and the pulse width modulation circuit 120 may be applicable to the embodiments described in the present disclosure.

FIG. 21 shows an exemplary connection diagram of the second signal terminal 50 and the first connection portion 51 in the display panel provided by the present disclosure. Referring to FIG. 15 and as shown in FIG. 21, in one embodiment of the present disclosure, the pulse amplitude modulation circuit 110 may include a second power supply terminal (corresponding to the power supply signal terminal VDD_PAM in FIG. 15), the display panel may include a second signal terminal 50 and a first connection portion 51, and the second power supply terminal VDD_PAM may be electrically connected to the second signal terminal 50 through the first connection portion 51. The second signal terminal 50 may be configured to transmit a second power supply voltage signal to the second power supply terminal VDD_PAM. The number of the second signal terminals 50 may be greater than the number of the first signal terminals 10. In one embodiment, the second signal terminal 50 may be a terminal for providing a second power voltage signal to the second power supply terminal in the pulse amplitude modulation circuit. Considering that the pulse amplitude modulation circuit may be connected to the light-emitting element, the magnitude of the driving current that drives the light-emitting element to emit light may be closely related to the magnitude of the second power supply voltage signal. Therefore, the transmission uniformity of the second power supply voltage signal may directly affect the display brightness uniformity of the light-emitting element in the display panel. In this embodiment, a large number of second signal terminals 50 may be set in the display panel, and the second power voltage signal may be provided to the pulse amplitude modulation circuit in the pixel circuit 20 through a large number of second signal terminals 50, which may be conducive to reducing the voltage drop of the second power voltage signal and improving the uniformity of the second power voltage signal received by the pixel circuit 20 in different regions, so it may be conducive to improving the overall display effect of the display panel.

Further, referring to FIG. 15 and FIG. 21, in embodiment of the present disclosure, the first connection portion 51 may be a planar structure. When the first connection portion 51 is set as a planar structure, it may be conducive to reducing the overall impedance of the first connection portion 51 and improving the rate of the second power voltage signal transmitted on the first connection portion 51. Thus, it may be conducive to reducing the size difference of the second power voltage signal in different regions and improving the overall display brightness uniformity of the display panel. When the first connection portion 51 is set as a planar structure, the second power supply terminal VDD_PAM in the pulse amplitude modulation circuit may be electrically connected to the first connection portion 51 by punching, without introducing a connection line, which may be conducive to simplifying the wiring complexity of the display panel.

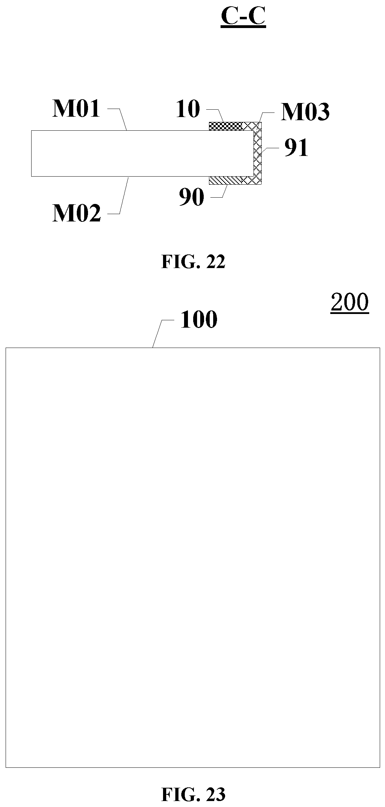

FIG. 22 shows a CC-sectional view of the display panel in FIG. 2. FIG. 22 only illustrates the first signal terminal 10, the side connection line 91 and the electrical connection terminal 90 in the display panel, and does not show the detailed film layer structure of the display panel. The detailed film layer structure of the display panel may refer to the prior art, and the present disclosure does not specifically limit this. As shown in FIG. 22, in one embodiment of the present disclosure, the non-light-emitting surface M02 of the display panel may be provided with an electrical connection terminal 90. The first signal terminal 10 may be electrically connected to the electrical connection terminal 90 through a side connection line 91. The side connection line 91 may be configured to extend from the light-emitting surface M01 of the display panel through the side of the display panel to the non-light-emitting surface M02 of the display panel. In this way, there may be no need to set a bonding area on the light-emitting surface M01 of the display panel to bond the flexible circuit board or the driver chip, which may be conducive to realizing an extremely narrow frame or a frameless design of the display panel. Multiple display panels of this structure may be spliced to form a larger display product. It should be noted that other signal terminals located on the light-emitting surface of the display panel may also be electrically connected to the electrical connection terminal located on the non-light-emitting surface of the display panel in a similar manner to the first signal terminal 10. This is not illustrated in the present disclosure.

The present disclosure also provides a display device. FIG. 23 shows a structural schematic diagram of an exemplary display device according to various disclosed embodiments of the present disclosure. As shown in FIG. 23, the display device 200 may include a display panel 100 in any of the above embodiments. The display device 200 provided in the embodiment of the present disclosure may be any electronic device with a display function, such as a touch screen, a mobile phone, a tablet computer, a laptop computer, an e-book or a television. The display device 200 provided in the embodiment of the present disclosure may have the beneficial effects of the display panel provided in the embodiments of the present disclosure. For details, reference may be made to the specific description of the display panel in the above embodiments, which will not be repeated in this embodiment.

It can be understood that FIG. 23 only illustrates a shape of the display device 200 by taking a rectangular structure as an example. In some other embodiments of the present disclosure, the display device 200 may also be embodied as a circle, an ellipse or any other feasible shape, which is not specifically limited in the present disclosure.

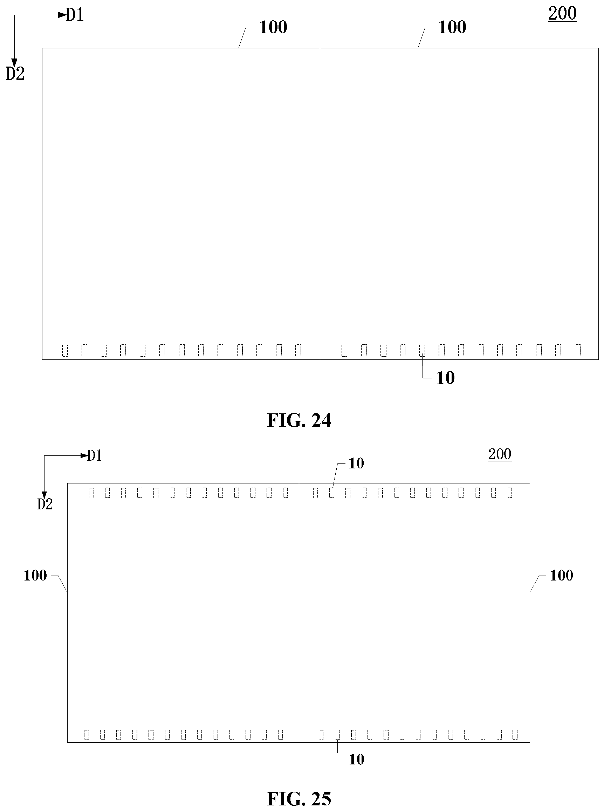

FIG. 24 and FIG. 25 respectively show a structural schematic diagram of another exemplary display device 200 provided in the embodiment of the present disclosure. As shown in FIG. 24 and FIG. 25, in one embodiment of the present disclosure, the display device 200 may include a plurality of display panels 100 spliced together. Along the second direction D2, the first signal terminal 10 may be located on the first side of the corresponding display panel, or the first signal terminal 100 may be located on both sides of the corresponding display panel.

FIG. 24 and FIG. 25 only illustrate the case where the display device includes two display panels, but the present disclosure is not limited to this. In some other embodiments of the present disclosure, the display device may also include more than two display panels. It should be noted that FIG. 24 and FIG. 25 only illustrate the case where two display panels are arranged along the first direction. In some other embodiments of the present disclosure, the display panels may also be arranged along the second direction. If more than four display panels are spliced, they may also be arranged in an array along the first direction and the second direction. The present disclosure is not limited to this. In the display device formed by splicing, the first signal terminal may be located on the first side or both sides of the corresponding display panel along the second direction. The position of the first signal terminal may be flexibly set according to actual needs, and the present disclosure does not specifically limit this.

The technical solution provided by the embodiments of the present disclosure may have the following advantages over the prior art.

In the present disclosure, a first group of signal terminals and a second group of signal terminals may be introduced into the display panel, and both the first group of signal terminals and the second group of signal terminals may be used to provide a first power supply voltage signal to the pixel circuit. The number of first signal terminals included in the second group of signal terminals may be greater than the number of first signal terminals included in the first group of signal terminals, and each first signal terminal may be electrically connected to a different first signal line, and the first power supply voltage signal may be provided to the pixel circuits in different display areas of the display panel through the first signal line. Thus, the area near the center line extending along the second direction of the display panel and the edge line extending along the second direction of the display panel may be connected to the first signal line. The first signal line connected to the first signal terminal may be introduced into the area near the edge. When the first power supply voltage signal is provided to the pixel circuit of the display area, each first signal terminal in the first group of signal terminals and the second group of signal terminals may transmit the first power supply voltage signal to the corresponding first signal line. Compared with the method of transmitting the power supply voltage signal through only one first signal terminal, the method of introducing multiple first signal terminals and corresponding multiple first signal lines in the present disclosure may be conducive to improving the transmission rate of the first power supply voltage signal and reducing the overall voltage drop of the first power supply voltage signal, thereby helping to weaken or avoid the display unevenness caused by the voltage drop problem of the first power supply voltage signal of the display panel. Thus, it may be conducive to improving the overall display brightness uniformity of the display panel. Moreover, a smaller number of first signal terminals may be set in the first group of signal terminals close to the edge, and a larger number of first signal terminals may be set in the second group of signal terminals away from the edge such that the first signal terminals may be arranged as evenly as possible along the first direction and transmit the first power supply voltage signal to the corresponding first signal line, thereby helping to reduce the display brightness difference between the display area around the first signal terminal and other display areas, thereby helping to improve the overall display brightness uniformity of the display panel.

It should be noted that, in this disclosure, relational terms such as "first" and "second" are only used to distinguish one entity or operation from another entity or operation, and do not necessarily require or imply any such actual relationship or order between these entities or operations. Moreover, the terms "include", "comprises" or any other variation thereof are intended to cover non-exclusive inclusion, so that a process, method, article or device including a series of elements includes not only those elements, but also other elements not explicitly listed, or also includes elements inherent to such process, method, article or device. In the absence of further restrictions, an element defined by the sentence "includes one..." does not exclude the presence of other identical elements in the process, method, article or device including the element.

The above is only a specific embodiment of the present disclosure, so that those skilled in the art can understand or implement the present disclosure. Various modifications to these embodiments will be obvious to those skilled in the art, and the general principles defined herein can be implemented in other embodiments without departing from the spirit or scope of the present disclosure. Therefore, the present disclosure will not be limited to the embodiments described herein, but will conform to the widest scope consistent with the principles and novel features disclosed herein.

## Claims

1. A display panel, **characterized by** comprising:
a display area, wherein a plurality of pixels are arranged in the display area, and the plurality of pixels are electrically connected to a pixel circuit; and
a plurality of first signal terminals arranged along a first direction and a plurality of first signal lines respectively connected to the plurality of first signal terminals, wherein
the plurality of first signal terminals are configured to provide a first power voltage signal to the pixel circuit through the plurality of first signal lines, the plurality of first signal lines extend along a second direction, and the first direction and the second direction intersect and are parallel to a light-emitting surface of the display panel;
the plurality of first signal terminals comprises a first group of signal terminals and a second group of signal terminals;
a number of first signal terminals included in the second group of signal terminals is greater than a number of first signal terminals included in the first group of signal terminals; and
along the first direction, the first group of signal terminals are located between the second group of signal terminals and an edge of the display panel.

2. The display panel according to claim 1, wherein a number of the second group of signal terminals is greater than a number of the first groups of signal terminals.

3. The display panel according to claim 1 or 2, wherein the first group of signal terminals comprises one first signal terminal of the plurality of first terminals, and the second group of signal terminal comprises two first signal terminals of the plurality of first terminals.

4. The display panel according to any one of claims 1 to 3, wherein along the first direction, a distance between any two adjacent first signal lines corresponding to the second group of signal terminals is less than a minimum distance between a first signal line corresponding to the first group of signal terminals and a first signal line corresponding to the second group of signal terminals.

5. The display panel according to any one of claims 1 to 4, wherein along the first direction, a minimum distance between a first signal line corresponding to the first group of signal terminals and a first signal line corresponding to the second group of signal terminals is S1, a width of the display panel along the first direction is S0, and S1/S0 is less than or equal to 1/2.

6. The display panel according to claim 5, wherein S1/S0 is less than or equal to 1/10.

7. The display panel according to claim 5, comprising:
at least two groups of the second group of signal terminals, wherein along the first direction, a minimum distance between first signal lines corresponding to two adjacent groups of second groups of signal terminals is S2, and S2 is equal to S1.

8. The display panel according to any one of claims 1 to 7, wherein
a first signal line connected to the first group of signal terminals is located between a first edge of the display panel and a first signal line connected to the second group of signal terminals;
the pixel circuit is excluded between the first signal line and the first edge; and
the first edge extends along the second direction.

9. The display panel according to any one of claims 1 to 7, comprising:
N1 pixel circuit columns arranged along the first direction, wherein a minimum number of pixel circuit columns of the N1 pixel circuit columns arranged between a first signal line connected to the first group of signal terminals and a first signal line connected to the second group of signal terminals is N2, and N2/N1 is less than or equal to 1/2.

10. The display panel according to claim 9, wherein N2/N1 is less than or equal to1/10.

11. The display panel according to any one of claims 1 to 10, comprising:
a plurality of pixel circuit columns arranged along the first direction; and
at least two groups of the second group of signal terminals, wherein
along the first direction, in a first group of signal terminals and an adjacent second group of signal terminals, a minimum number of pixel circuit columns arranged between a first signal line connected to the first group of signal terminals and a first signal line connected to the second group of signal terminals is n1;
in two adjacent groups of second groups of signal terminals, a number of the pixel circuit columns arranged between the first signal lines respectively connected to the two adjacent groups of the second group of signal terminals is n2; and
n1 is equal to n2.

12. The display panel according to claim 11, wherein
in the second group of signal terminals, the pixel circuit is excluded between at least two first signal lines connected to the plurality of first signal terminals; or
in the second group of signal terminals, the pixel circuit is provided between at least two first signal lines connected to the plurality of first signal terminals.

13. The display panel according to any one of claims 1 to 2 and 4 to 12, wherein the second group of signal terminals comprises two first signal terminals of the plurality of first signal terminals, and along the first direction, a distance between first signal lines connected to the two first signal terminals in the second group of signal terminals is less than 625µm.

14. The display panel according to any one of claims 1 to 2 and 4 to 12, wherein a number of the second group of signal terminals is Q, Q is greater than or equal to 3, and Q is an odd number.

15. The display panel according to claim 14, wherein Q is equal to 9.

16. The display panel according to any one of claims 1 to 15, wherein the display area comprises:
N sub-display areas with equal width arranged along the first direction, wherein the second group of signal terminals are located between an n-th sub-display area and an (n+1)-th sub-display area, and n is greater than or equal to 1 and less than or equal to N-1.

17. The display panel according to claim 16, wherein N is equal to 10.

18. The display panel according to claim 17, comprising:
two first group of signal terminals, wherein the two first group of signal terminals are located between the edge of the display panel and the second group of signal terminals.

19. The display panel according to claim 16, wherein the first group of signal terminals comprises one first signal terminal, and the second group of signal terminals comprises two first signal terminals.

20. The display panel according to claim 19, wherein in the second group of signal terminals, the pixel circuit is excluded between the first signal lines correspondingly connected to two first signal terminals.

21. The display panel according to claim 20, wherein distances between adjacent groups of the second group of signal terminals are equal.

22. The display panel according to any one of claims 1 to 21, further comprising:
a plurality of first connection lines extending along the first direction and arranged along the second direction, wherein,
the plurality of first connection lines and the plurality of first signal lines are arranged in different layers;
the plurality of first connection lines are configured to transmit the first power voltage signal to the pixel circuit;
along the direction perpendicular to a plane where the light-emitting surface of the display panel is located, the plurality of first signal lines and the plurality of first connection lines overlap to form a plurality of first overlapping areas; and
in the plurality of first overlapping areas, the plurality of first signal lines and the plurality of first connection lines are electrically connected through first connection holes.

23. The display panel according to claim 22, further comprising:
a plurality of second connection lines extending along the second direction and arranged along the first direction, wherein,
the plurality of second connection lines are located between adjacent columns of the pixel circuits;
along a direction perpendicular to a plane where the light-emitting surface of the display panel is located, the plurality of second connection lines overlap with the plurality of first connection lines to form a plurality of second overlapping areas; and
in the plurality of second overlapping areas, the plurality of first connection lines and the plurality of second connection lines are electrically connected through second connection holes.

24. The display panel according to claim 23, wherein along the first direction, a width of the second connection line is greater than or equal to a width of the first signal line.

25. The display panel according to any one of claims 1 to 24, further comprising:
a plurality of second signal lines extending along the first direction and arranged along the second direction, wherein,
the plurality of second signal lines are configured to transmit display control signals to the pixel circuit;
the plurality of first signal lines comprises a plurality of first openings; and
the plurality of first openings overlap with the plurality of second signal lines along a direction perpendicular to a plane where the light-emitting surface of the display panel is located.

26. The display panel according to any one of claims 1 to 25, wherein,
the pixel circuit is configured to provide a driving current to the plurality of pixels;
the pixel circuit comprises a pulse amplitude modulation circuit and a pulse width modulation circuit;
the pulse amplitude modulation circuit is configured to control an amplitude of the driving current based on applied pulse amplitude modulation data;
the pulse width modulation circuit is configured to control a pulse width of the driving current;
the pulse width modulation circuit comprises a first power supply terminal; and
the first power supply terminal is electrically connected to the first signal terminal through the first signal line.

27. The display panel according to claim 26, wherein,
the pulse amplitude modulation circuit comprises a second power supply terminal;
the display panel comprises a second signal terminal and a first connection portion;
the second power supply terminal is electrically connected to the second signal terminal through the first connection portion;
the second signal terminal is configured to transmit a second power supply voltage signal to the second power supply terminal; and
a number of the second signal terminals is greater than a number of the first signal terminals.

28. The display panel according to claim 1, wherein,
a non-light-emitting surface of the display panel is provided with an electrical connection terminal;
the first signal terminal is electrically connected to the electrical connection terminal through a side connection line; and
the side connection line is configured to extend from the light-emitting surface of the display panel through a side surface of the display panel to the non-light-emitting surface of the display panel.

29. A display device, **characterized by** comprising a display panel according to any one of claims 1 to 28.

30. The display device according to claim 29, comprising:
at least two display panels arranged in a splicing manner, wherein along the second direction, the first signal terminal is located on a first side of a corresponding display panel of the at least two display panels, or the first signal terminal is located at two sides of the corresponding display panel of the at least two display panels.
